# EUROPEAN PATENT APPLICATION

(11) **EP 4 529 380 A1**
(43) Date of publication of application: **26.03.2025**
(21) Application number: 24167220.3
(22) Date of filing: 28.03.2024
(51) Int. Cl.: H10B 12/00, H01L 21/764

(54) **SEMICONDUCTOR DEVICE**

(30) Priority: 21.09.2023 KR 20230126470
(71) Applicant: Samsung Electronics Co., Ltd., Suwon-si, Gyeonggi-do 16677 (KR)
(72) Inventor: LEE, Hosang, 16677 Suwon-si, Gyeonggi-do (KR); PARK, Taejin, 16677 Suwon-si, Gyeonggi-do (KR); LEE, Hyeon-Kyu, 16677 Suwon-si, Gyeonggi-do (KR); YIM, Sung Soo, 16677 Suwon-si, Gyeonggi-do (KR)
(74) Representative: Kuhnen & Wacker Patent- und Rechtsanwaltsbüro PartG mbB

(57) **Abstract**

A semiconductor device may include a first bit line that extends in a first direction, a first active pillar and a second active pillar on the first bit line, a first gate insulating pattern enclosing the first active pillar, a second gate insulating pattern on the second active pillar, a first word line and a second word line that extends in a second direction that intersects the first direction, and a protection pattern between the first and second word lines. An air gap is between the first and second word lines and may be adjacent to the protection pattern.

## Description

### CROSS-REFERENCE TO RELATED APPLICATIONS

This U.S. non-provisional patent application claims priority under 35 U.S.C. §119 to Korean Patent Application No. 10-2023-0126470, filed on September 21, 2023, in the Korean Intellectual Property Office, the entire contents of which are hereby incorporated by reference.

### BACKGROUND

The present disclosure relates to a semiconductor device, and in particular, to a semiconductor device including vertical channel transistors.

As a semiconductor device is scaled down, it may be desired to develop a fabrication technology capable of increasing an integration density of a semiconductor device and improving an operation speed and a production yield. Thus, semiconductor devices with vertical channel transistors have been suggested to increase an integration density of a semiconductor device and improve resistance and current driving characteristics of the transistor.

### SUMMARY

Embodiments of the inventive concept provides a semiconductor device with improved electrical characteristics and an increased integration density.

According to some embodiments of the inventive concept, a semiconductor device may include a first bit line that extends in a first direction, a first active pillar and a second active pillar on the first bit line, a first gate insulating pattern on the first active pillar, a second gate insulating pattern on the second active pillar, a first word line and a second word line that extend in a second direction that intersects the first direction, and a protection pattern between the first and second word lines. An air gap is between the first and second word lines and may be adjacent the protection pattern.

According to some embodiments of the inventive concept, a semiconductor device may include a first bit line that extends in a first direction, a first active pillar and a second active pillar on the first bit line, a first gate insulating pattern on the first active pillar, a second gate insulating pattern on the second active pillar, and a first word line and a second word line that extends in a second direction that intersects the first direction. The protection pattern may include a first portion in contact with the first word line and a second portion in contact with the second word line, and an air gap may be between the first and second portions of the protection pattern.

According to some embodiments of the inventive concept, a semiconductor device may include a first bit line and a second bit line that extends in a first direction, a first word line and a second word line that extends in a second direction that intersects the first direction, a first active pillar and a second active pillar on the first bit line, a third active pillar and a fourth active pillar on the second bit line, a data contact electrically connected to each of the first to fourth active pillars, a landing pad electrically connected to the data contact, a data storage pattern electrically connected to the landing pad, a first gate insulating pattern, a second gate insulating pattern, a third gate insulating pattern, and a fourth gate insulating pattern on the first, second, third, and fourth active pillars, respectively, a protection pattern between the first and second word lines, and an insulating structure on the first word line, the second word line, and the protection pattern. The first word line may be on the first and third gate insulating patterns, and the second word line may be on the second and fourth gate insulating patterns. The protection pattern may include a first portion in contact with the first word line, a second portion in contact with the second word line, and a third portion connecting the first and second portions to each other. The first, second, and third portions of the protection pattern may define an air gap.

### BRIEF DESCRIPTION OF THE DRAWINGS

FIG. 1A is a plan view illustrating a semiconductor device according to some embodiments of the inventive concept.
FIG. 1B and 1C are perspective views schematically illustrating a semiconductor device according to some embodiments of the inventive concept.
FIG. 2A is a plan view illustrating a semiconductor device according to some embodiments of the inventive concept.
FIG. 2B is a sectional view taken along a line A1-A1' of FIG. 2A.
FIG. 2C is a sectional view taken along a line B 1-B 1' of FIG. 2A.
FIG. 2D is an enlarged view illustrating a portion E1 of FIG. 2A.
FIG. 2E is an enlarged view illustrating a portion E2 of FIG. 2A.
FIGS. 3A, 3B, 4A, 4B, 5A, 5B, 6A, 6B, 7A, 7B, 8A, 8B, 9A, 9B, 10A, 10B, 11A, 11B, 12A, 12B, 13A, 13B, 14A, and 14B are diagrams illustrating a method of fabricating a semiconductor device, according to some embodiments of the inventive concept.
FIG. 15A is a plan view illustrating a semiconductor device according to some embodiments of the inventive concept.
FIG. 15B is a sectional view taken along a line A2-A2' of FIG. 15A.
FIG. 15C is a sectional view taken along a line B2-B2' of FIG. 15A.
FIGS. 16A, 16B, 17A, 17B, 18A, 18B, 19A, 19B, 20A, 20B, 21A, 21B, 22A, 22B, 23A, and 23B are diagrams illustrating a method of fabricating a semiconductor device, according to some embodiments of the inventive concept.
FIG. 24A is a plan view illustrating a semiconductor device according to some embodiments of the inventive concept.
FIG. 24B is a sectional view taken along a line A3-A3' of FIG. 24A.
FIG. 24C is a sectional view taken along a line B3-B3' of FIG. 24A.
FIG. 25A is a plan view illustrating a semiconductor device according to some embodiments of the inventive concept.
FIG. 25B is a sectional view taken along a line A4-A4' of FIG. 25A.
FIG. 25C is a sectional view taken along a line B4-B4' of FIG. 25A.
FIG. 26A is a plan view illustrating a semiconductor device according to some embodiments of the inventive concept.
FIG. 26B is a sectional view taken along a line A5-A5' of FIG. 26A.
FIG. 26C is a sectional view taken along a line B5-B5' of FIG. 26A.
FIG. 27A is a plan view illustrating a semiconductor device according to some embodiments of the inventive concept.
FIG. 27B is a sectional view taken along a line A6-A6' of FIG. 27A.
FIG. 27C is a sectional view taken along a line B6-B6' of FIG. 27A.
FIG. 27D is an enlarged view illustrating a portion E3 of FIG. 27A.
FIG. 28A is a plan view illustrating a semiconductor device according to some embodiments of the inventive concept.
FIG. 28B is a sectional view taken along a line A7-A7' of FIG. 28A.
FIG. 28C is a sectional view taken along a line B7-B7' of FIG. 28A.
FIG. 29A is a plan view illustrating a semiconductor device according to some embodiments of the inventive concept.
FIG. 29B is a sectional view taken along a line A8-A8' of FIG. 29A.
FIG. 29C is a sectional view taken along a line B8-B8' of FIG. 29A.
FIG. 29D is an enlarged view illustrating a portion E4 of FIG. 29A.

### DETAILED DESCRIPTION

Example embodiments of the inventive concepts will now be described more fully with reference to the accompanying drawings, in which example embodiments are shown.

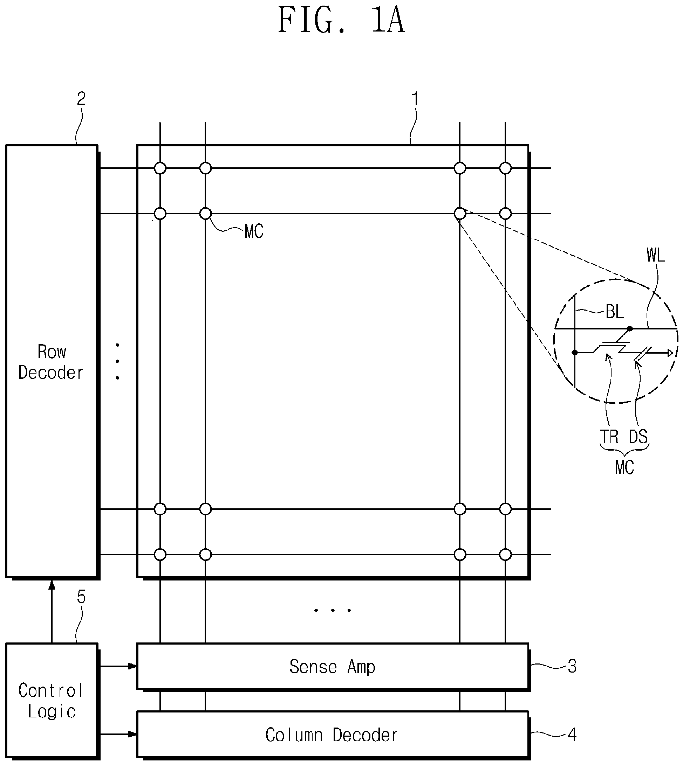

FIG. 1A is a block diagram illustrating a semiconductor device according to some embodiments of the inventive concept.

Referring to FIG. 1A, a semiconductor device may include a memory cell array 1, a row decoder 2, a sense amplifier 3, a column decoder 4, and a control logic 5.

The memory cell array 1 may include a plurality of memory cells MC, which are two- or three-dimensionally arranged. Each of the memory cells MC may be provided between and connected to a word line WL and a bit line BL, which are provided to cross or intersect each other but are spaced apart from one another. The term "connected" may be used herein to refer to a physical and/or electrical connection.

Each of the memory cells MC may include a selection element TR and a data storing element DS. The selection element TR and the data storing element DS may be electrically connected to each other. The selection element TR may be connected to both of the word and bit lines WL and BL. In other words, the selection element TR may be provided at an intersection of the word and bit lines WL and BL.

The selection element TR may include a field effect transistor. The data storing element DS may include a capacitor, a magnetic tunnel junction pattern, or a variable resistor. As an example, the selection element TR may be a transistor whose gate, source, and drain terminals are connected to the word line WL, the bit line BL, and the data storing element DS, respectively.

The row decoder 2 may be configured to decode address information, which is input from the outside, i.e. external to the device, and to select one of the word lines WL of the memory cell array 1, based on the decoded address information. The address information decoded by the row decoder 2 may be provided to a row driver (not shown), and in this case, the row driver may provide respective voltages to the selected one of the word lines WL and the unselected ones of the word lines WL, in response to the control of a control circuit.

The sense amplifier 3 may be configured to sense, amplify, and output a difference in voltage between one of the bit lines BL, which is selected based on address information decoded by the column decoder 4, and a reference bit line.

The column decoder 4 may establish a data transmission path between the sense amplifier 3 and an external device (e.g., a memory controller). The column decoder 4 may be configured to decode address information, which is input from the outside, and to select one of the bit lines BL, based on the decoded address information.

The control logic 5 may generate control signals, which are used to control an operation of writing or reading data to or from the memory cell array 1.

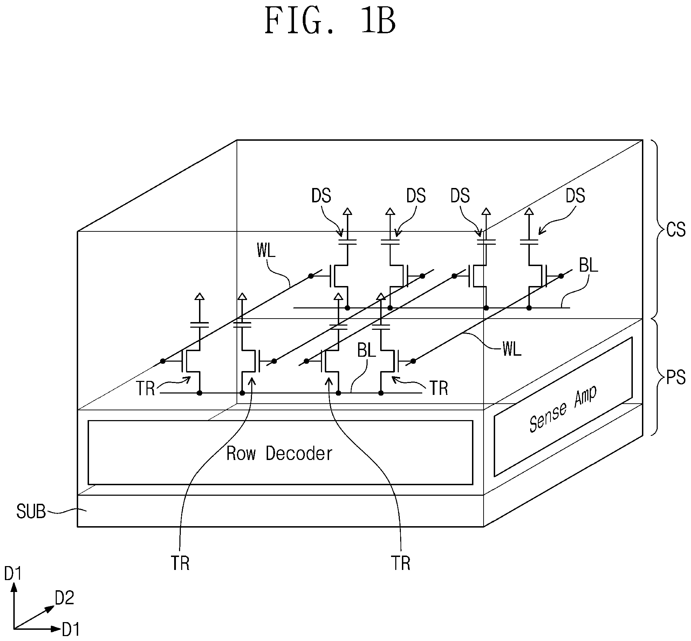

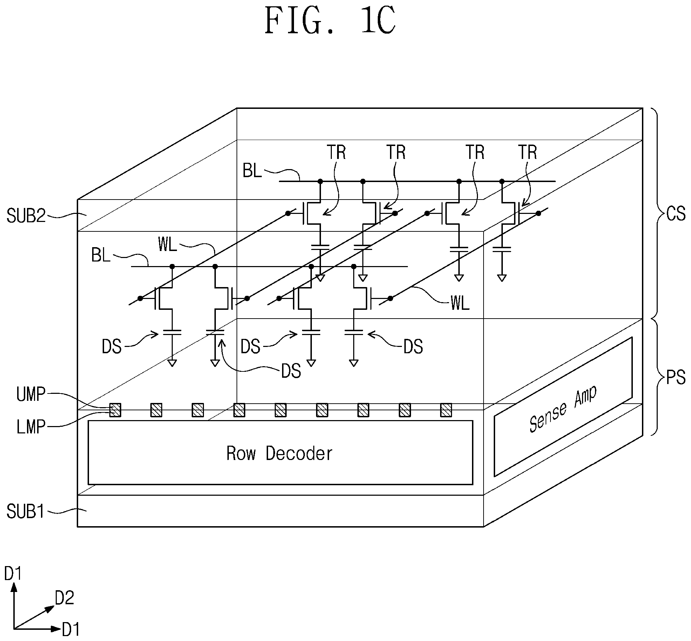

FIGS. 1B and 1C are perspective views schematically illustrating a semiconductor device according to some embodiments of the inventive concept.

Referring to FIGS. 1B and 1C, the semiconductor device may include a peripheral circuit structure PS and a cell array structure CS, which are connected to each other.

The peripheral circuit structure PS may include core and peripheral circuits, which are formed on a substrate SUB. The core and peripheral circuits may include the row and column decoders 2 and 4, the sense amplifier 3, and the control logics 5 described with reference to FIG. 1A.

The cell array structure CS may include the memory cell array 1, in which the memory cells MC are two-dimensional or three-dimensionally arranged (e.g., see FIG. 1A). Each of the memory cells MC of FIG. 1A may include the selection element TR and the data storing element DS, as described above.

In some embodiments, the selection element TR of each of the memory cells MC of FIG. 1A may include a vertical channel transistor (VCT). The vertical channel transistor may have a channel region whose lengthwise direction is substantially normal to a top surface of the substrate SUB. The data storing element DS of each of the memory cells MC of FIG. 1A may include a capacitor.

In the embodiments of FIG. 1B, the peripheral circuit structure PS may be provided on the substrate SUB, and the cell array structure CS may be provided on the peripheral circuit structure PS.

In the embodiments of FIG. 1C, the peripheral circuit structure PS may be provided on a first substrate SUB 1, and the cell array structure CS may be provided on a second substrate SUB2. The first and second substrates SUB1 and SUB2 may be provided to face each other.

First metal pads LMP may be provided in the uppermost portion of the peripheral circuit structure PS. The first metal pads LMP may be electrically connected to the core and peripheral circuits 2, 3, 4, and 5 of FIG. 1A.

Second metal pads UMP may be provided in the lowermost portion of the cell array structure CS. The second metal pads UMP may be electrically connected to the memory cell array 1 of FIG. 1A. The second metal pads UMP may be directly bonded to (i.e., in direct contact with) the first metal pads LMP of the peripheral circuit structure PS.

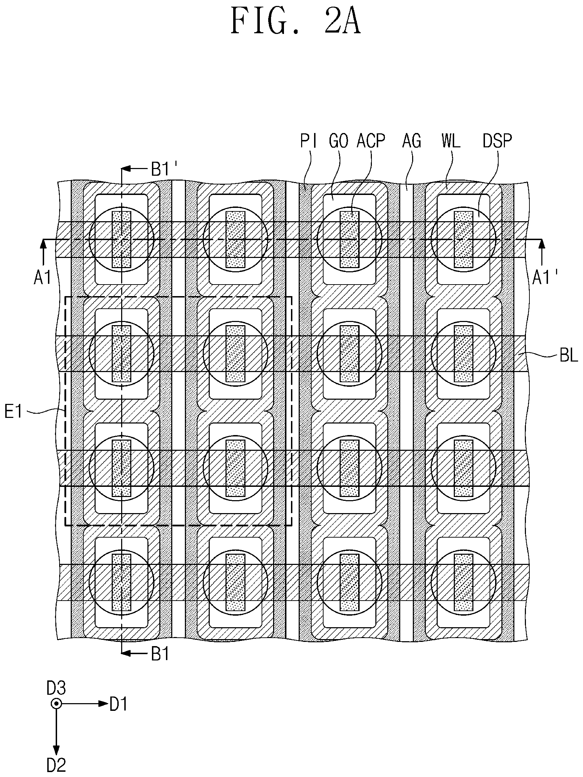

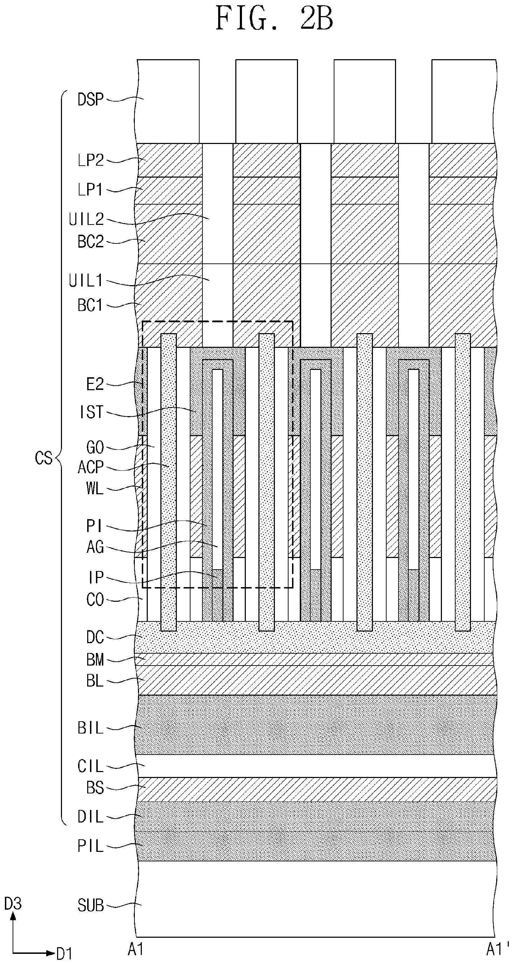

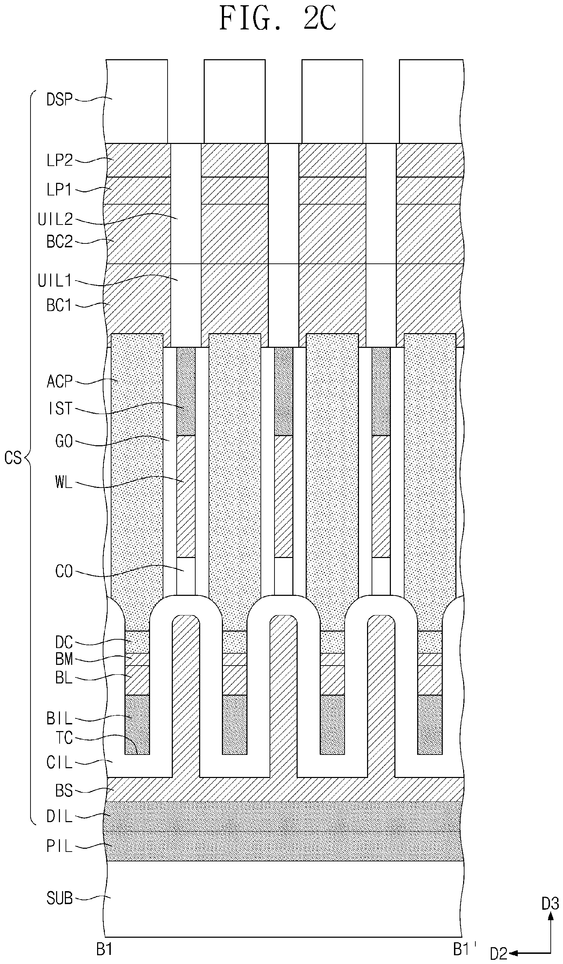

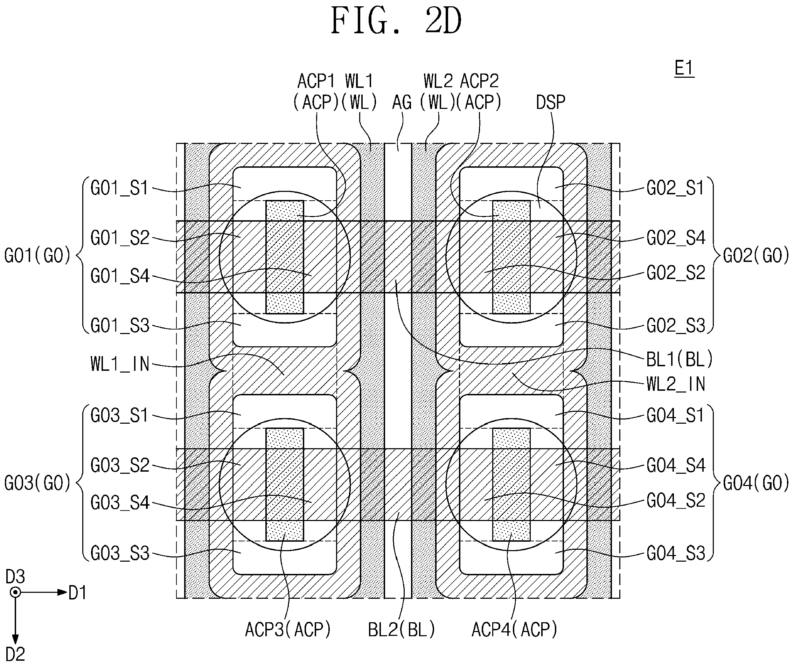

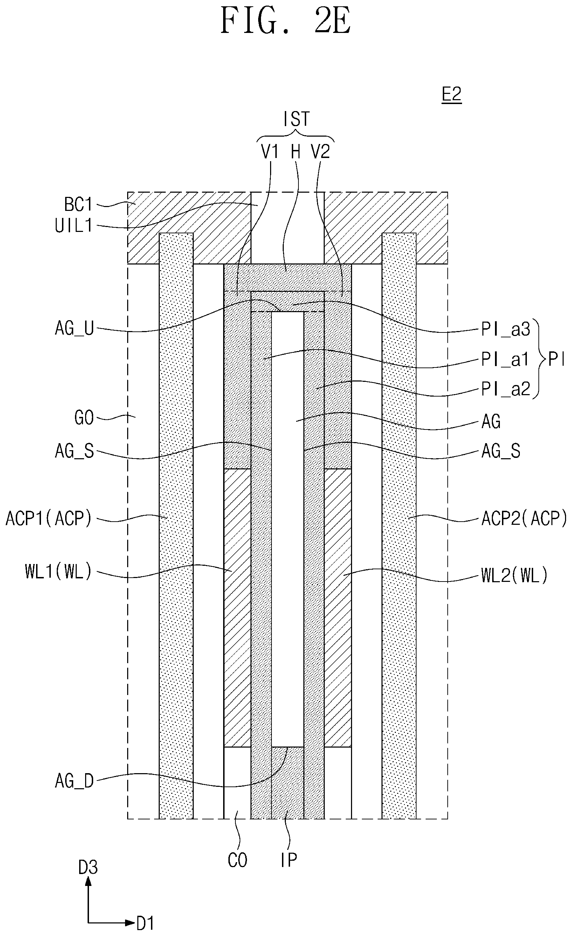

FIG. 2A is a plan view illustrating a semiconductor device according to some embodiments of the inventive concept. FIG. 2B is a sectional view taken along a line A1-A1' of FIG. 2A. FIG. 2C is a sectional view taken along a line B 1-B 1' of FIG. 2A. FIG. 2D is an enlarged view illustrating a portion E1 of FIG. 2A. FIG. 2E is an enlarged view illustrating a portion E2 of FIG. 2B.

Referring to FIGS. 2A to 2E, a peripheral circuit insulating layer PIL may be provided on the substrate SUB. The substrate SUB may be a plate-shaped structure that is extended parallel to a plane defined by a first direction D1 and a second direction D2. The first and second directions D1 and D2 may be non-parallel to each other. In some embodiments, the first and second directions D1 and D2 may be two different horizontal directions, which are orthogonal to each other. The peripheral circuit insulating layer PIL may include an insulating material. As an example, the peripheral circuit insulating layer PIL may be formed of or include at least one of nitride materials.

In some embodiments, the peripheral circuit structure PS described with reference to FIG. 1B may be provided between the substrate SUB and the peripheral circuit insulating layer PIL. In some embodiments, an integrated circuit (e.g., a logic device) may be provided between the substrate SUB and the peripheral circuit insulating layer PIL.

A lower insulating layer DIL may be provided on the peripheral circuit insulating layer PIL. In some embodiments, the peripheral circuit insulating layer PIL and the lower insulating layer DIL may be bonded to each other through a wafer bonding process.

The cell array structure CS may be provided on the lower insulating layer DIL. The cell array structure CS may include memory cells, each of which includes a vertical channel transistor. The cell array structure CS may include a bit line protection layer BS, a capping insulating layer CIL, bit line insulating layers BIL, bit lines BL, barrier layers BM, connection layers DC, active pillars ACP, supporting insulating layers CO, blocking patterns IP, word lines WL, air gap AG, gate insulating patterns GO, protection patterns PI, insulating structures IST, upper insulating layers UIL1, UIL2, data contacts BC1 and BC2, landing pads LP1 and LP2, and data storage patterns DSP.

The bit line protection layer BS may be provided on the lower insulating layer DIL. The bit line protection layer BS may include a planar portion and a protruding portion on the planar portion. The planar portion of the bit line protection layer BS may be extended in the first and second directions D1 and D2. The protruding portion of the bit line protection layer BS may protrude in a third direction D3. The third direction D3 may be non-parallel to the first and second directions D1 and D2. As an example, the third direction D3 may be a vertical direction that is orthogonal to the first and second directions D1 and D2.

The uppermost level of the protruding portion of the bit line protection layer BS may be higher than a level of the connection layer DC. The uppermost level of the protruding portion of the bit line protection layer BS may be higher than a level of a bottom surface of the active pillar ACP. The protruding portion of the bit line protection layer BS may be disposed between the bit lines BL to suppress an electric interference issue between the bit lines BL. The bit line protection layer BS may include a conductive material. As an example, the bit line protection layer BS may include a metal-containing material. In some embodiments, the bit line protection layer BS may be formed of a dielectric material.

The capping insulating layer CII, may be provided on the bit line protection layer BS. The capping insulating layer CIL may cover, overlap, or be on the planar and protruding portions of the bit line protection layer BS. The capping insulating layer CIL may be disposed between the bit lines BL. The capping insulating layer CII, may be provided to separate the bit lines BL from each other. Surfaces of the capping insulating layer CIL may define a trench TC. The capping insulating layer CIL may include an insulating material. As an example, the capping insulating layer CII, may be formed of or include at least one of oxide materials.

The bit line insulating layers BIL may be provided on the capping insulating layer CIL. The bit line insulating layer BIL may be disposed in the trench TC of the capping insulating layer CIL. The bit line insulating layer BIL may be extended in the first direction D1. The bit line insulating layers BIL may be spaced apart from each other in the second direction D2 with the capping insulating layer CIL interposed therebetween. The bit line insulating layer BIL may include an insulating material. As an example, the bit line insulating layer BIL may be formed of or include at least one of nitride materials.

The bit lines BL may be provided on the bit line insulating layers BIL. The bit line BL may be disposed in the trench TC of the capping insulating layer CIL. The bit line BL may be extended in the first direction D1. The bit lines BL may be spaced apart from each other in the second direction D2 with the capping insulating layer CIL interposed therebetween.

The bit line BL may include a conductive material. For example, the bit line BL may be formed of or include at least one of doped polysilicon, metallic materials (e.g., Al, Cu, Ti, Ta, Ru, W, Mo, Pt, Ni, Co), conductive metal nitride materials (e.g., TiN, TaN, WN, NbN, TiAlN, TiSiN, TaSiN, RuTiN), conductive metal silicide materials, or conductive metal oxide materials (e.g., PtO, RuO₂, IrO₂, SrRuO₃ (SRO), (Ba,Sr)RuO₃ (BSRO), CaRuO₃ (CRO), LSCo), but the inventive concept is not limited to this example. The bit line BL may be a single- or multi-layered structure formed of the afore-described materials. In some embodiments, the bit line BL may be formed of or include at least one of two-dimensional semiconductor materials (e.g., graphene, carbon nanotube, or combinations thereof).

The barrier layers BM may be provided on the bit lines BL. The barrier layer BM may be disposed in the trench TC of the capping insulating layer CIL. The barrier layer BM may be extended in the first direction D1. In some embodiments, the barrier layer BM may include a plurality of layers. The barrier layers BM may be spaced apart from each other in the second direction D2 with the capping insulating layer CIL interposed therebetween. The barrier layer BM may be in contact with the bit line BL. The barrier layer BM may include a conductive material. As an example, the barrier layer BM may be formed of or include TiN.

the connection layers DC may be provided on the barrier layers BM. The connection layer DC may be disposed in the trench TC of the capping insulating layer CIL. The connection layer DC may be extended in the first direction D1. In some embodiments, the connection layer DC may include a plurality of layers. The connection layers DC may be spaced apart from each other in the second direction D2 with the capping insulating layer CIL interposed therebetween. The connection layer DC may electrically connect the active pillar ACP to the bit line BL. The connection layer DC may include a conductive material. As an example, the connection layer DC may be formed of or include doped silicon.

The active pillars ACP may be provided on the connection layer DC. Each of the connection layers DC may be in contact with a plurality of active pillars ACP. The active pillars ACP may be arranged on the bit lines BL to be spaced apart from each other in the first and second directions D1 and D2 and form a matrix shape.

The active pillar ACP may have a tetragonal or rectangular shape. A width of the active pillar ACP in the first direction D1 may be smaller than a width in the second direction D2. The shape of the active pillar ACP is not limited to this example and may be variously changed.

The active pillar ACP may be formed of or include a semiconductor material. The active pillar ACP may be formed of or include at least one of oxide semiconductor materials (e.g., InGaZnO, InGaSiO, InSnZnO, InZnO, ZnO, ZnSnO, ZnON, ZrZnSnO, SnO, HfInZnO, GaZnSnO, AlZnSnO, YbGaZnO, or InGaO), but the inventive concept is not limited to this example. As an example, the active pillar ACP may be formed of or include indium gallium zinc oxide (IGZO). The active pillar ACP may include a single or multiple layer made of at least one of the oxide semiconductor materials. The active pillar ACP may be formed of or include an amorphous, single-crystalline, or poly-crystalline oxide semiconductor material. In some embodiments, the active pillar ACP may have a band gap energy that is greater than that of silicon. In some embodiments, the active pillar ACP may have a band gap energy of about 1.5 eV to 5.6 eV. For example, the active pillar ACP may exhibit an optimized channel performance, when it has a band gap energy of about 2.0 eV to 4.0 eV. In some embodiments, the active pillar ACP may have a polycrystalline or amorphous structure, but the inventive concept is not limited to this example. In some embodiments, the active pillar ACP may be formed of or include at least one of two-dimensional semiconductor materials (e.g., graphene, carbon nanotube, or combinations thereof).

The gate insulating patterns GO may be provided to enclose the active pillar ACP. The gate insulating patterns GO may be disposed on the connection layer DC. The gate insulating patterns GO may be provided to separate the active pillars ACP from each other.

The gate insulating pattern GO may be formed of or include at least one of insulating materials. The gate insulating pattern GO may be formed of or include at least one of silicon oxide, silicon oxynitride, or high-k dielectric materials whose dielectric constants are higher than that of silicon oxide. The high-k dielectric material may include metal oxide materials or metal oxynitride materials. For example, the high-k dielectric material for the gate insulating pattern GO may include at least one of HfO₂, HfSiO, HfSiON, HfTaO, HfTiO, HfZrO, ZrO₂, or Al₂O₃, but the inventive concept is not limited to this example.

A supporting insulating layer CO may be provided on the capping insulating layer CII, and the connection layer DC. The supporting insulating layer CO may be disposed between the gate insulating patterns GO, which are adjacent to each other. The supporting insulating layer CO may be in contact with the adjacent ones of the gate insulating patterns GO. The supporting insulating layer CO may include an insulating material. As an example, the supporting insulating layer CO may be formed of or include at least one of oxide materials.

The word lines WL may be provided on the supporting insulating layer CO. A bottom surface of the word line WL may be in contact with a top surface of the supporting insulating layer CO. Each of the word line WL may enclose the active pillars ACP arranged in the second direction D2. The word lines WL may be spaced apart from each other in the first direction D1. The word line WL may be extended in the second direction D2.

The word line WL may include a conductive material. The word line WL may be formed of or include at least one of, for example, doped polysilicon, metallic materials (e.g., Al, Cu, Ti, Ta, Ru, W, Mo, Pt, Ni, Co), conductive metal nitride materials (e.g., TiN, TaN, WN, NbN, TiAlN, TiSiN, TaSiN, RuTiN), conductive metal silicide materials, or conductive metal oxide materials, but the inventive concept is not limited to this example. The word line WL may be a single- or multi-layered structure formed of the afore-described materials. In some embodiments, the word line WL may be formed of or include at least one of two-dimensional semiconductor materials (e.g., graphene, carbon nanotube, or combinations thereof).

The protection patterns PI may be provided on the connection layer DC. The protection pattern PI may be disposed between adjacent ones of the word lines WL. The protection pattern PI may be in contact with the adjacent ones of the word lines WL. The protection pattern PI may be disposed between adjacent ones of the supporting insulating layers CO. The protection pattern PI may be in contact with the adjacent ones of the supporting insulating layers CO.

The blocking patterns IP may be provided on the connection layer DC. The blocking pattern IP may be in contact with the connection layer DC and the protection pattern PI.

The insulating structure IST may be provided on the word lines WL and the protection patterns PI. The insulating structure IST may be disposed between the gate insulating patterns GO, which are adjacent to each other. The insulating structure IST may be in contact with a top surface of the word line WL. The insulating structure IST may be in contact with the adjacent ones of the gate insulating patterns GO and the protection pattern PI.

The protection pattern PI, the blocking pattern IP, and the insulating structure IST may include at least one insulating material. In some embodiments, the protection pattern PI, the blocking pattern IP, and the insulating structure IST may be formed of or include at least one of nitride materials.

First data contacts BC1 may be provided on the active pillars ACP, second data contacts BC2 may be provided on the first data contacts BC1, first landing pads LP1 may be provided on the second data contacts BC2, and second landing pads LP2 may be provided on the first landing pads LP1.

The first data contact BC1, the second data contact BC2, the first landing pad LP1, and the second landing pad LP2 may be vertically overlapped with the active pillar ACP and may be spaced apart from each other in the first and second directions D1 and D2, thereby forming a matrix shape. The first and second data contacts BC1 and BC2 may connect the active pillar ACP to the first and second landing pads LP1 and LP2.

The first and second data contacts BC1 and BC2 may include a conductive material. The first and second data contacts BC1 and BC2 may be formed of or include at least one of doped silicon, Al, Cu, Ti, Ta, Ru, W, Mo, Pt, Ni, Co, TiN, TaN, WN, NbM, TiAl, TiAlN, TiSi, TiSiN, TaSi, TaSiN, RuTiN, NiSi, CoSi, IrOx, RuOx, or combinations thereof, but the inventive concept is not limited to this example or a specific embodiment. In the case where the first and second data contacts BC1 and BC2 include doped silicon, a doping concentration of the first data contact BC1 may be lower than a doping concentration of the second data contact BC2.

When viewed in a plan view, the first and second landing pads LP1 and LP2 may be spaced apart from each other in the first and second directions D1 and D2 and may be arranged to form various shapes (e.g., a matrix shape, a zigzag shape, and a honeycomb shape). When viewed in a plan view, each of the landing pads LP may have various shapes (e.g., circular, elliptical, rectangular, square, diamond, and hexagonal shapes).

The first and second landing pads LP1 and LP2 may include a conductive material. The first and second landing pads LP1 and LP2 may be formed of or include at least one of doped silicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or combinations thereof, but the inventive concept is not limited to this example or a specific embodiment.

A first upper insulating layer UIL1 may be provided between the first data contacts BC1. The first upper insulating layer UIL1 may be provided on the insulating structure IST. The first upper insulating layer UIL1 may separate the first data contacts BC1 from each other.

A second upper insulating layer UIL2 may be provided between the second data contacts BC2, between the first landing pads LP1, and between the second landing pads LP2. The second upper insulating layer UIL2 may be provided on the first upper insulating layer UIL1. The second upper insulating layer UIL2 may separate vertical connection structures, each of which consists of the second data contact BC2, the first landing pad LP1, and the second landing pad LP2, from each other.

The first and second upper insulating layers UIL1 and UIL2 may include at least one insulating material. In some embodiments, the first and second upper insulating layers UIL1 and UIL2 may be formed of or include at least one of oxide materials. In some embodiments, the first and second upper insulating layers UIL1 and UIL2 may be a multi-layered structure including a plurality of insulating layers.

The data storage patterns DSP may be provided on the second landing pads LP2, respectively. The data storage pattern DSP may be electrically connected to the active pillar ACP through the data contacts BC1 and BC2 and the landing pads LP1 and LP2.

In some embodiments, the data storage patterns DSP may be a capacitor and may include bottom and top electrodes and a capacitor dielectric layer interposed therebetween. In this case, the bottom electrode may be in contact with the second landing pad LP2 and may have various shapes (e.g., circular, elliptical, rectangular, square, diamond, and hexagonal shapes), when viewed in a plan view.

In some embodiments, the data storage pattern DSP may be a variable resistance pattern whose resistance can be switched to one of at least two states by an electric pulse applied thereto. For example, the data storage pattern DSP may be formed of or include at least one of phase-change materials whose crystal state can be changed depending on an amount of a current applied thereto, perovskite compounds, transition metal oxides, magnetic materials, ferromagnetic materials, or antiferromagnetic materials.

Referring to FIG. 2D, the bit lines BL may include a first bit line BL1 and a second bit line BL2, which are adjacent to each other in the second direction D2. The first and second bit lines BL1 and BL2 may be arranged in the second direction D2.

The word lines WL may include a first word line WL1 and a second word line WL2, which are adjacent to each other in the first direction D1. The first and second word lines WL1 and WL2 may be arranged in the first direction D1. The protection pattern PI may be disposed between the first and second word lines WL1 and WL2.

The active pillars ACP may include a first active pillar ACP1, a second active pillar ACP2 spaced apart from the first active pillar ACP1 in the first direction D1, a third active pillar ACP3 spaced apart from the first active pillar ACP1 in the second direction D2, and a fourth active pillar ACP4 spaced apart from the third active pillar ACP3 in the first direction D1. The first active pillar ACP1 may be adjacent to the second active pillar ACP2 in the first direction D1. The first active pillar ACP1 may be adjacent to the third active pillar ACP3 in the second direction D2. The first and second active pillars ACP1 and ACP2 may be disposed on the first bit line BL1. The third and fourth active pillars ACP3 and ACP4 may be disposed on the second bit line BL2.

The gate insulating patterns GO may include a first gate insulating pattern GO1 enclosing the first active pillar ACP1, a second gate insulating pattern GO2 enclosing the second active pillar ACP2, a third gate insulating pattern GO3 enclosing the third active pillar ACP3, and a fourth gate insulating pattern GO4 enclosing the fourth active pillar ACP4, in plan view. The first to fourth gate insulating patterns GO1, GO3, GO2, and GO4 may be spaced apart from each other.

The first word line WL1 may enclose the first and third gate insulating patterns GO1 and GO3 in plan view. The second word line WL2 may enclose the second and fourth gate insulating patterns GO2 and GO4. The insulating structure IST may be disposed between the first and second gate insulating patterns GO1 and GO2.

The first to fourth gate insulating patterns GO1, GO2, GO3, and GO4 may include first sidewalls GO1_S1, GO2_S1, GO3_S1, and GO4_S1, second sidewalls GO1_S2, GO2_S2, GO3_S2, and GO4_S2, third sidewalls GO1_S3, GO2_S3, GO3_S3, and GO4_S3, and fourth sidewalls GO1_S4, GO2_S4, GO3_S4, and GO4_S4. The first sidewalls GO1_S1, GO2_S1, GO3_S1, and GO4_S1 and the third sidewalls GO1_S3, GO2_S3, GO3_S3, and GO4_S3 may be extended in the first direction D1. The second sidewalls GO1_S2, GO2_S2, GO3_S2, and GO4_S2 and the fourth sidewalls GO1_S4, GO2_S4, GO3_S4, and GO4_S4 may be extended in the second direction D2. The first sidewalls GO1_S1, GO2_S1, GO3_S1, and GO4_S1 and the third sidewalls GO1_S3, GO2_S3, GO3_S3, and GO4_S3 may be spaced apart from each other in the second direction D2. The second sidewalls GO1_S2, GO2_S2, GO3_S2, and GO4_S2 and the fourth sidewalls GO1_S4, GO2_S4, GO3_S4, and GO4_S4 may be spaced apart from each other in the first direction D1.

The first word line WL1 may be in contact with the first sidewalls GO1_S1 and GO3_S1, the second sidewalls GO1_S2 and GO3_S2, the third sidewalls GO1_S3 and GO3_S3, and the fourth sidewalls GO1_S4 and GO3_S4 of the first and third gate insulating patterns GO1 and GO3. The second word line WL2 may be in contact with the first sidewalls GO2_S1 and GO4_S1, the second sidewalls GO2_S2 and GO4_S2, the third sidewalls GO2_S3 and GO4_S3, and the fourth sidewalls GO2_S4 and GO4_S4 of the second and fourth gate insulating patterns GO2 and GO4.

The third sidewall GO1_S3 of the first gate insulating pattern GO1 may be adjacent to the first sidewall GO3_S1 of the third gate insulating pattern GO3. The third sidewall GO2_S3 of the second gate insulating pattern GO2 may be adjacent to the first sidewall GO4_S1 of the fourth gate insulating pattern GO4. The first word line WL1 may include an intervening portion WL1_IN, which is interposed between the third sidewall GO1_S3 of the first gate insulating pattern GO1 and the first sidewall GO3_S1 of the third gate insulating pattern GO3. The second word line WL2 may include an intervening portion WL2_IN, which is interposed between the third sidewall GO2_S3 of the second gate insulating pattern GO2 and the first sidewall GO4_S1 of the fourth gate insulating pattern GO4.

Referring to FIG. 2E, the protection pattern PI may include a first portion PI_a1 in contact with the first word line WL1, a second portion PI_a2 in contact with the second word line WL2, and a third portion PI_a3 connecting the first portion PI_a1 to the second portion PI_a2. The first portion PI_a1 of the protection pattern PI may be adjacent to the first active pillar ACP1. The second portion PI_a2 of the protection pattern PI may be adjacent to the second active pillar ACP2. The blocking pattern IP may be disposed between the first and second portions PI_a1 and PI_a2 of the protection pattern PI.

An air gap AG may be defined between the first and second word lines WL1 and WL2 by the protection pattern PI. The air gap AG may be defined between the first and second portions PI_a1 and PI_a2 of the protection pattern PI. Side surfaces AG_S of the air gap AG may be defined by side surfaces of the first and second portions PI_a1 and PI_a2 of the protection pattern PI. A top surface AG_U of the air gap AG may be defined by a bottom surface of the third portion PI_a3 of the protection pattern PI. A bottom surface AG_D of the air gap AG may be defined by a top surface of the blocking pattern IP.

The insulating structure IST may include a first vertical portion V1 in contact with a top surface of the first word line WL1, a second vertical portion V2 in contact with a top surface of the second word line WL2, and a horizontal portion H connecting the first vertical portion V1 to the second vertical portion V2. The first vertical portion V1 may be disposed between the first active pillar ACP1 and the protection pattern PI. The first vertical portion V1 may be in contact with the first active pillar ACP1 and the protection pattern PI. The second vertical portion V2 may be disposed between the second active pillar ACP2 and the protection pattern PI. The second vertical portion V2 may be in contact with the second active pillar ACP2 and the protection pattern PI. The horizontal portion H may be in contact with the third portion PI_a3 of the protection pattern PI.

When measured in the first direction D1, a width of the first portion PI_a1 of the protection pattern PI may be smaller than a width of each of the active pillar ACP, the gate insulating pattern GO, and the air gap AG. A width of the air gap AG in the second direction D2 may be larger than a width of each of the first to fourth gate insulating patterns GO1, GO2, GO3, and GO4 in the second direction D2. A distance between the bottom and top surfaces AG_D and AG_U of the air gap AG may be larger than a distance between bottom and top surfaces of the word line WL.

A level of the top surface AG_U of the air gap AG may be higher than a level of the word line WL. A level of the third portion PI_a3 of the protection pattern PI may be higher than the level of the word line WL. A level of the horizontal portion H of the insulating structure IST may be higher than the level of the word line WL.

In the semiconductor device according to some embodiments of the inventive concept, the protection pattern PI may be provided between adjacent ones of the word lines WL to define the air gap AG. Thus, it may be possible to reduce the electric interference issue between the word lines WL and improve the electrical characteristics of the semiconductor device.

In the semiconductor device according to some embodiments of the inventive concept, the word line WL may be interposed between the gate insulating patterns GO. Accordingly, an integration density of the semiconductor device may be increased.

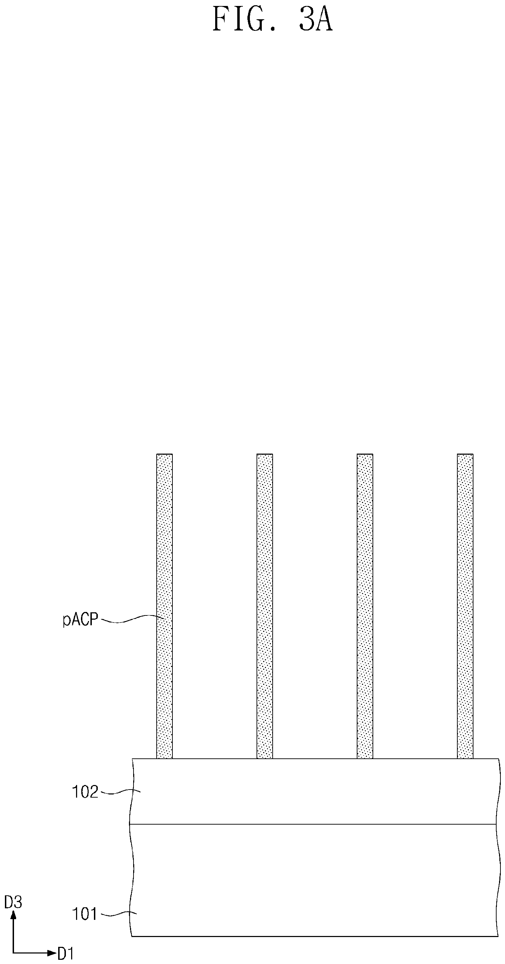

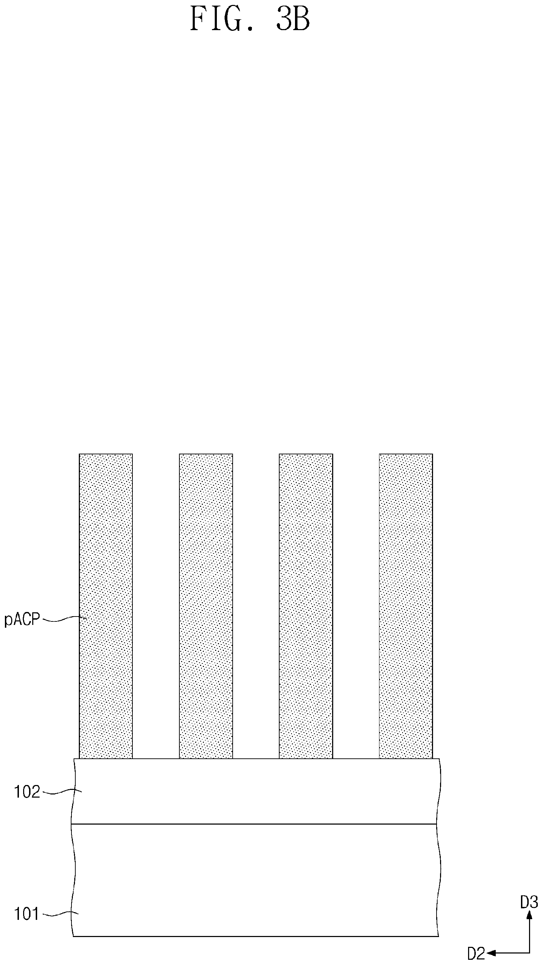

FIGS. 3A, 3B, 4A, 4B, 5A, 5B, 6A, 6B, 7A, 7B, 8A, 8B, 9A, 9B, 10A, 10B, 11A, 11B, 12A, 12B, 13A, 13B, 14A, and 14B are diagrams illustrating a method of fabricating a semiconductor device, according to some embodiments of the inventive concept. FIGS. 3A, 4A, 5A, 6A, 7A, 8A, 9A, 10A, 11A, 12A, 13A, and 14A illustrate a portion corresponding to FIG. 2B. FIGS. 3B, 4B, 5B, 6B, 7B, 8B, 9B, 10B, 11B, 12B, 13B, and 14B illustrate a portion corresponding to FIG. 2C.

Referring to FIGS. 3A and 3B, a wafer substrate 101, a wafer insulating layer 102 on the wafer substrate 101, and preliminary active pillars pACP on the wafer insulating layer 102 may be formed. As an example, the wafer substrate 101 may include a silicon-on-insulator (SOI) substrate or a germanium-on-insulator (GOI) substrate. In some embodiments, the wafer substrate 101 may be formed of or include at least one of silicon, germanium, silicon-germanium, gallium-phosphorus, or gallium-arsenic. The wafer insulating layer 102 may include an insulating material. As an example, the wafer insulating layer 102 may be formed of or include at least one of oxide materials.

In some embodiments, the formation of the preliminary active pillars pACP may include forming an upper substrate on the wafer insulating layer 102, forming a photoresist pattern on the upper substrate, and patterning the upper substrate using the photoresist patterns as an etch mask. As a result of the patterning, the upper substrate may be divided into the preliminary active pillars pACP.

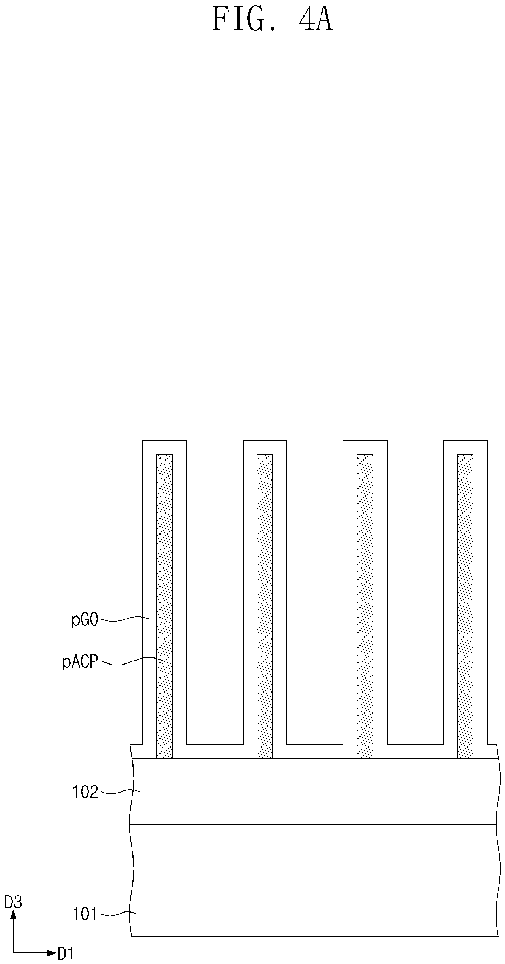

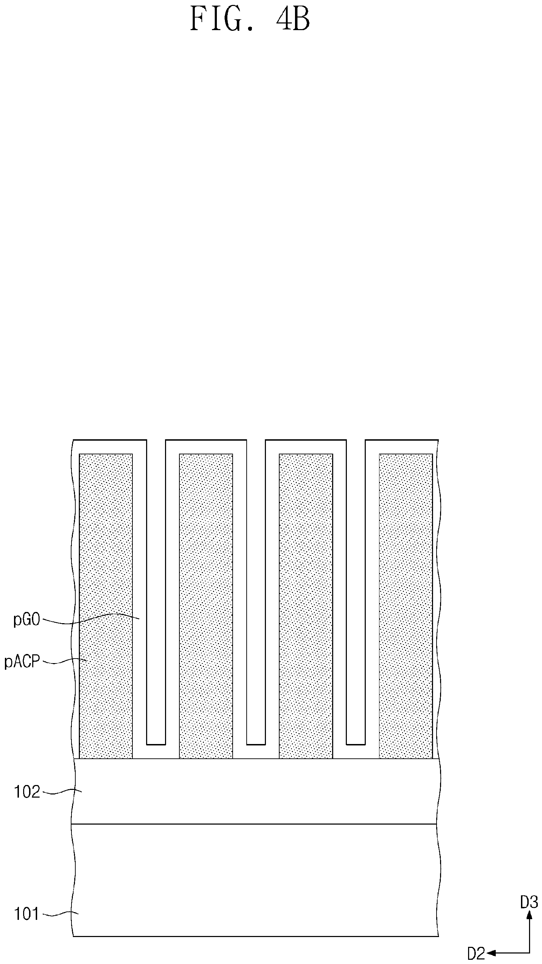

Referring to FIGS. 4A and 4B, a preliminary gate insulating pattern pGO may be formed. The preliminary gate insulating pattern pGO may be formed of or include at least one of insulating materials. The preliminary gate insulating pattern pGO may be conformally formed on the wafer insulating layer 102 and the preliminary active pillars pACP. In some embodiments, the preliminary gate insulating pattern pGO may be formed through a chemical vapor deposition process. In some embodiments, the preliminary gate insulating pattern pGO may be formed through a wet oxidation process.

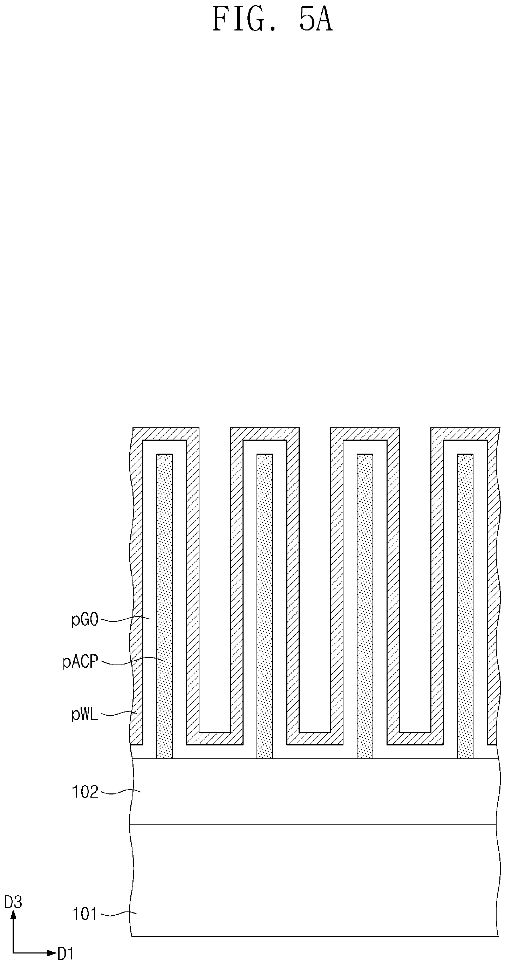

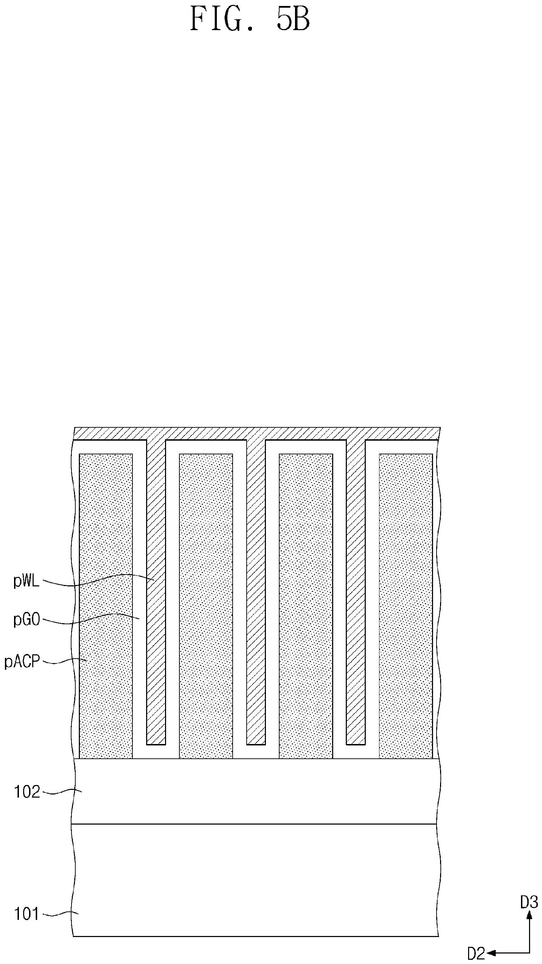

Referring to FIGS. 5A and 5B, a preliminary word line pWL may be formed. The preliminary word line pWL may include a conductive material.

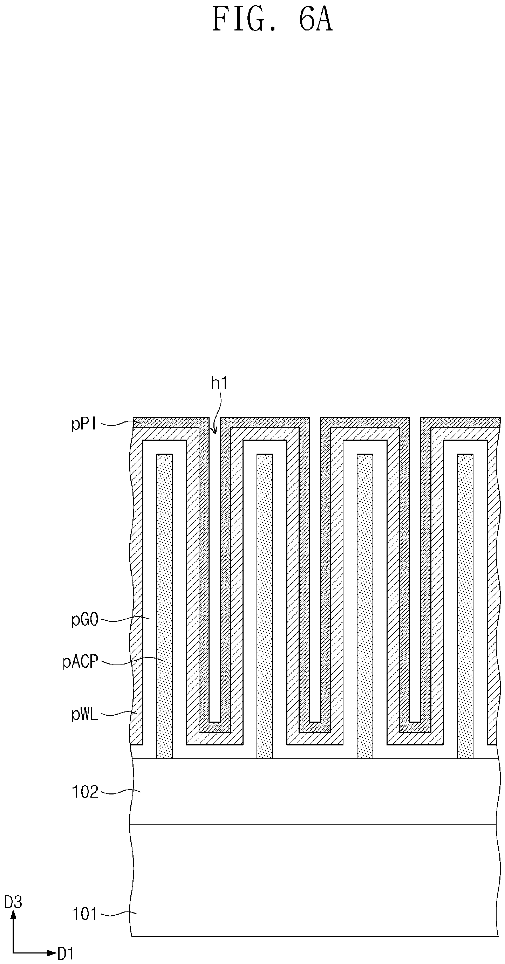

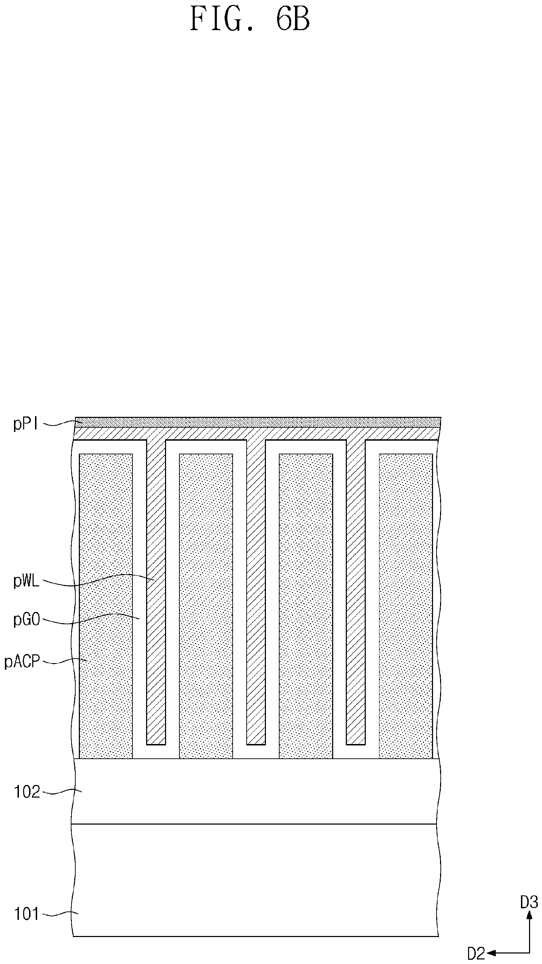

Referring to FIGS. 6A and 6B, a preliminary protection pattern pPI may be formed. The preliminary protection pattern pPI may be formed of or include at least one of insulating materials. The preliminary protection pattern pPI may be conformally formed on the preliminary word line pWL. In some embodiments, the preliminary protection pattern pPI may be formed through an atomic layer deposition process.

An empty space h1 may be formed in the preliminary protection pattern pPI. The empty space h1 in the preliminary protection pattern pPI may be defined by surfaces of the preliminary protection pattern pPI disposed between the preliminary active pillars pACP.

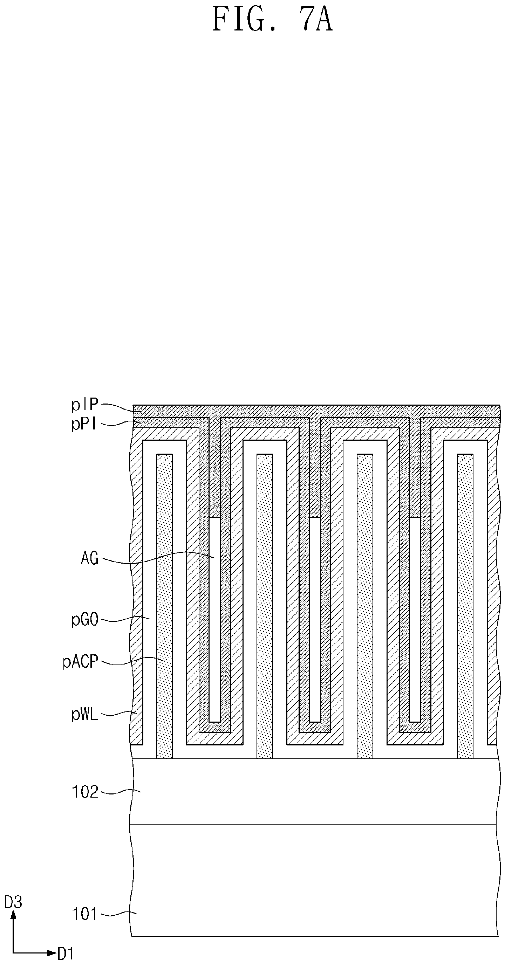

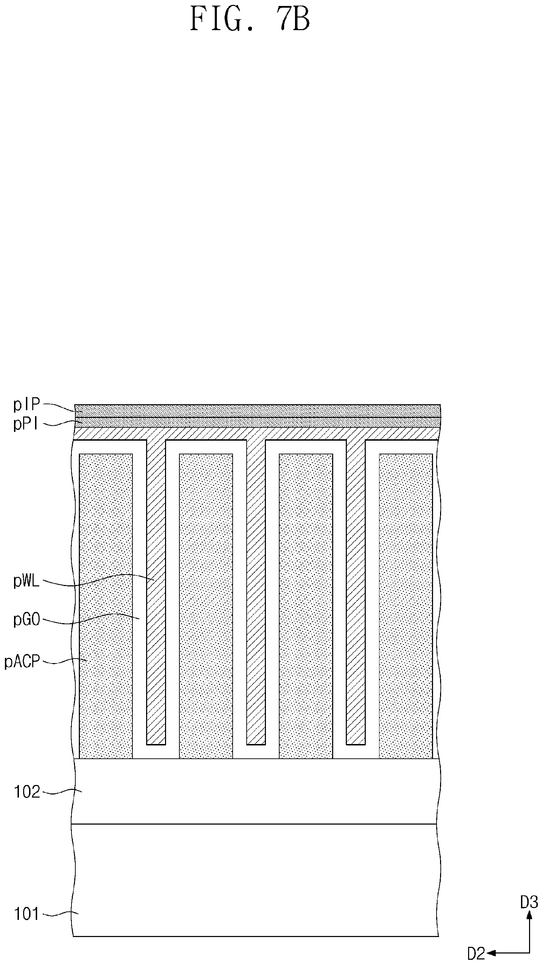

Referring to FIGS. 7A and 7B, a preliminary blocking pattern pIP may be formed on the preliminary protection pattern pPI. The preliminary blocking pattern pIP may fill an upper portion of the empty space h1 in the preliminary protection pattern pPI. The preliminary blocking pattern pIP may not fill a lower portion of the empty space h1 in the preliminary protection pattern pPI. The lower portion of the empty space h1 in the preliminary protection pattern pPI may be defined as the air gap AG. The air gap AG may be closed by the preliminary blocking pattern pIP and the preliminary protection pattern pPI. The preliminary blocking pattern pIP may be formed of or include at least one of insulating materials.

In some embodiments, the air gap AG may be formed by forming the preliminary protection pattern pPI through an atomic layer deposition process and by forming the preliminary blocking pattern pIP through a chemical vapor deposition process.

In some embodiments, an insulating layer may be formed to fill the empty space h1 in the preliminary protection pattern pPI, the preliminary blocking pattern pIP may be formed on the insulating layer, and then, the air gap AG may be formed by removing the insulating layer using, for example, a dry cleaning process.

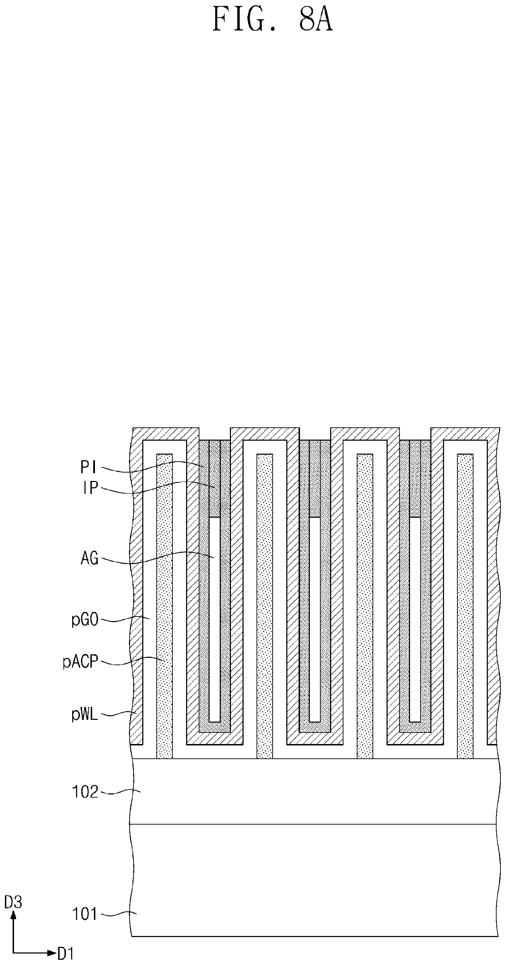

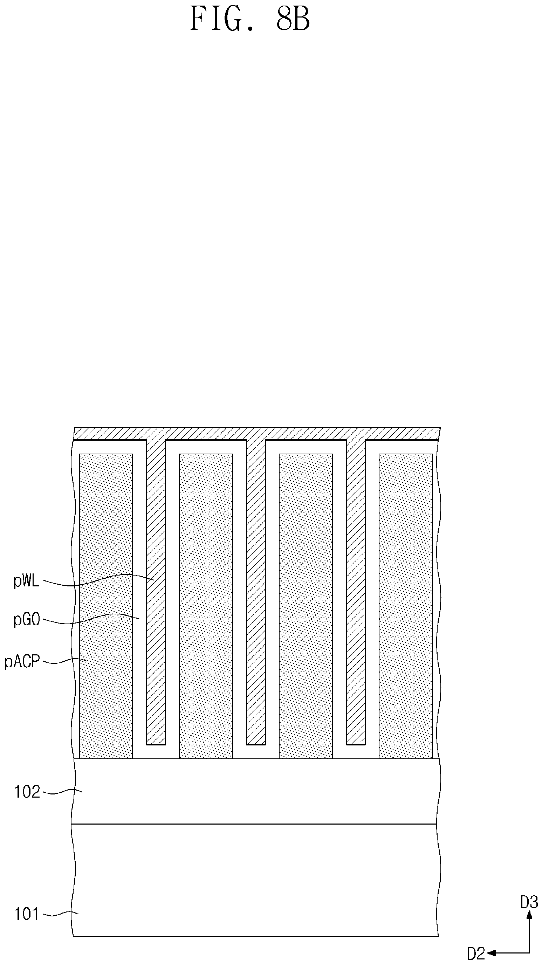

Referring to FIGS. 8A and 8B, a portion of the preliminary protection pattern pPI and a portion of the preliminary blocking pattern pIP may be removed. As a result of the partial removal of the preliminary protection pattern pPI and the preliminary blocking pattern pIP, the preliminary word line pWL may be exposed to the outside. As used herein, the term "exposed" may indicate that an element isn't completely isolated but may be adjacent to another element or entity, such as outside the device. A remaining portion of the preliminary blocking pattern pIP may be defined as the blocking pattern IP. A remaining portion of the preliminary protection pattern pPI may be defined as the protection pattern PI. In some embodiments, the portion of the preliminary protection pattern pPI and the portion of the preliminary blocking pattern pIP may be removed by an etch-back process.

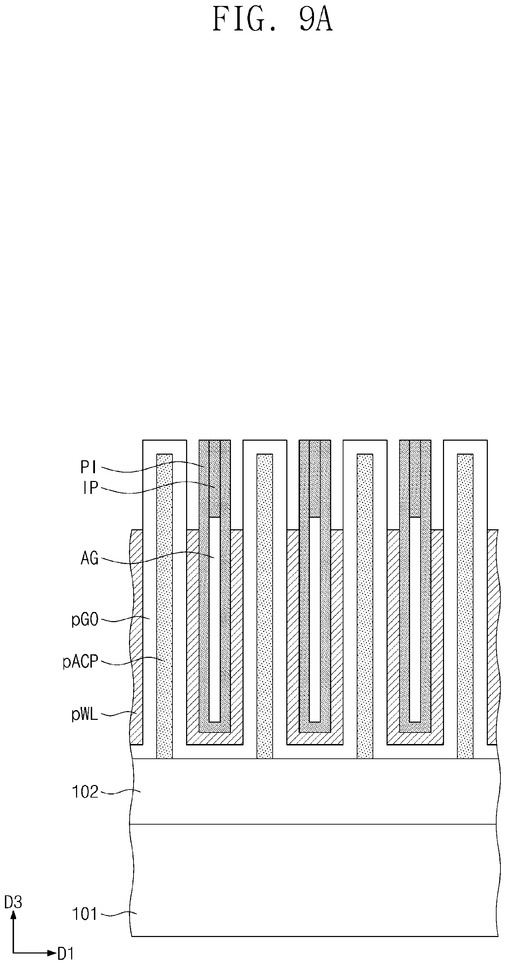

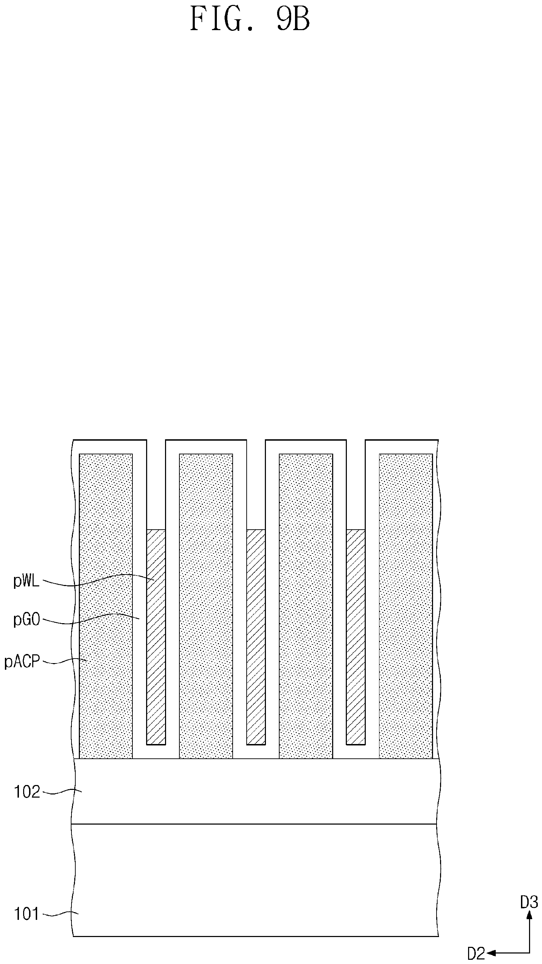

Referring to FIGS. 9A and 9B, a portion of the preliminary word line pWL may be removed. As a result of the partial removal of the preliminary word line pWL, the preliminary gate insulating pattern pGO may be exposed to the outside. In some embodiments, the portion of the preliminary word line pWL may be removed by an etch-back process.

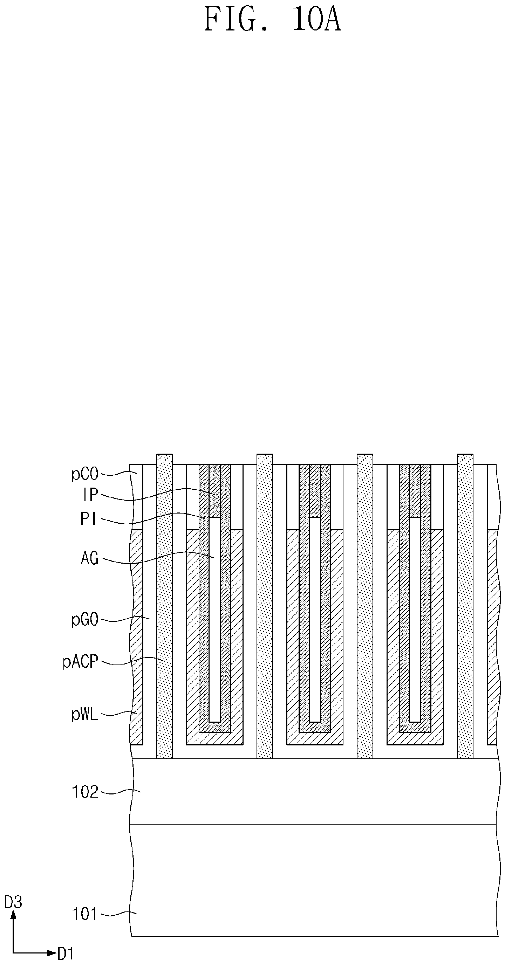

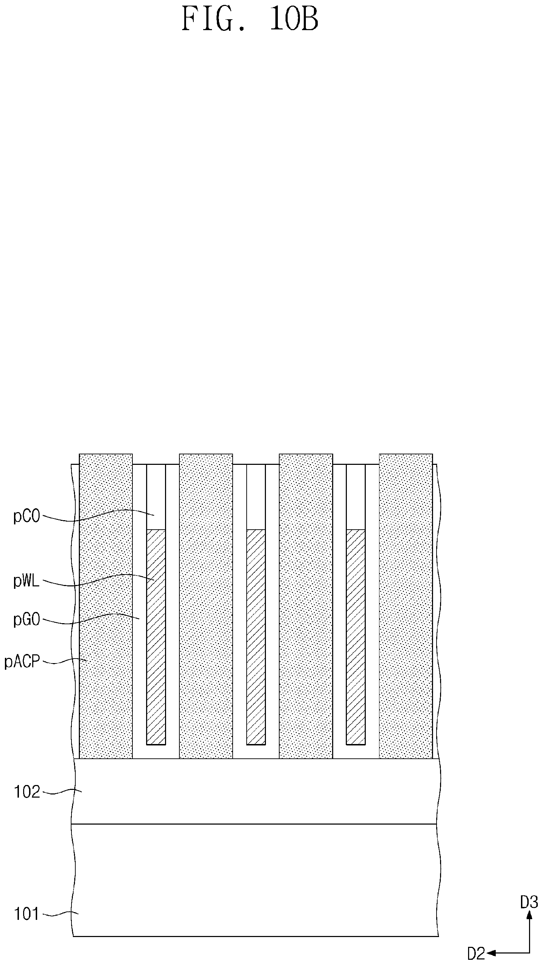

Referring to FIGS. 10A and 10B, a preliminary supporting insulating layer pCO may be formed. The preliminary supporting insulating layer pCO may be formed on the preliminary word line pWL. The preliminary supporting insulating layer pCO may be formed of or include at least one of insulating materials. In some embodiments, the preliminary supporting insulating layer pCO may be formed through a chemical vapor deposition process.

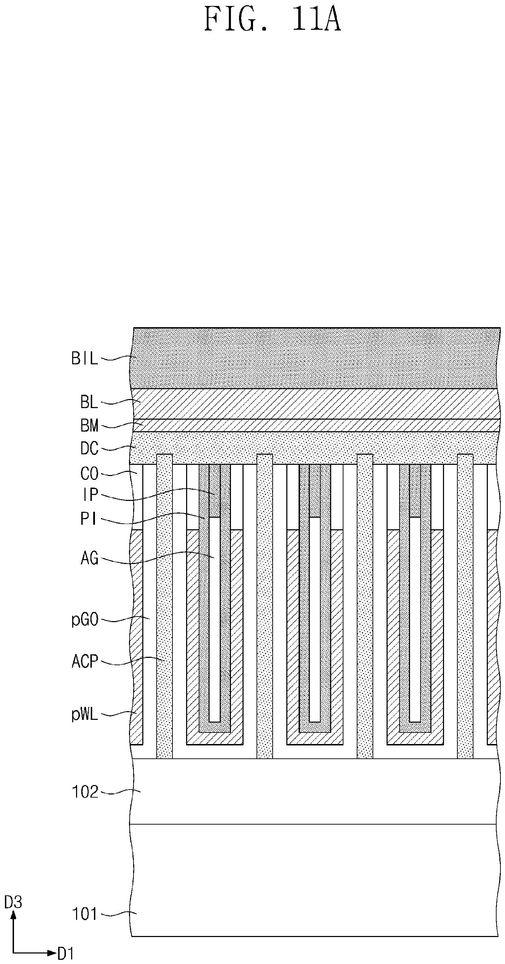

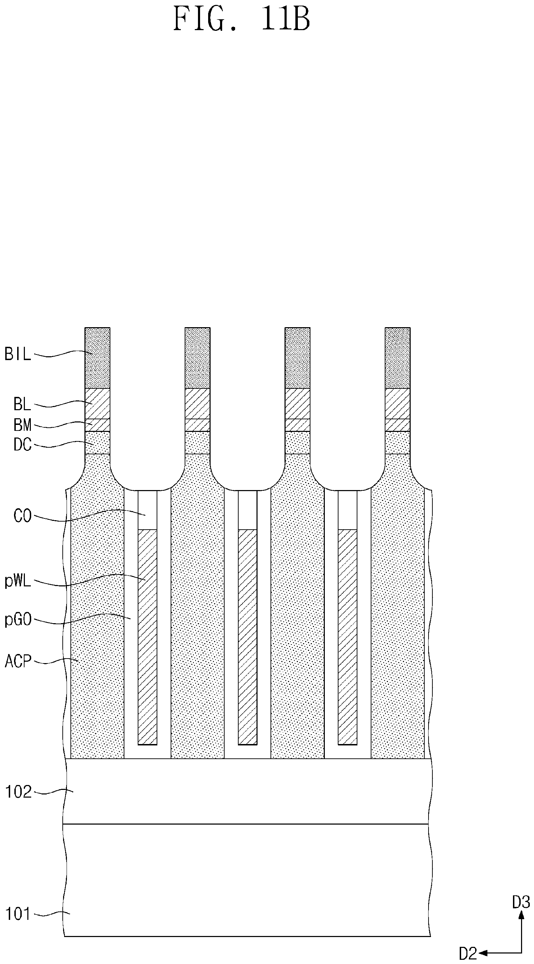

Referring to FIGS. 11A and 11B, the supporting insulating layers CO, the connection layers DC, the barrier layers BM, the bit lines BL, and the bit line insulating layers BIL may be formed. The formation of the supporting insulating layers CO, the connection layers DC, the barrier layers BM, the bit lines BL, and the bit line insulating layers BIL may include forming a preliminary connection layer, forming a preliminary barrier layer on the preliminary connection layer, forming a preliminary bit line on the preliminary barrier layer, forming a preliminary bit line insulating layer on the preliminary bit line, and patterning the preliminary supporting insulating layer pCO, the preliminary connection layer, the preliminary barrier layer, the preliminary bit line, and the preliminary bit line insulating layer.

The patterned preliminary supporting insulating layer may be defined as the supporting insulating layer CO. The patterned preliminary connection layer may be defined as the connection layer DC. The patterned preliminary barrier layer may be defined as the barrier layer BM. The patterned preliminary bit line may be defined as the bit line BL. The patterned preliminary bit line insulating layer may be defined as the bit line insulating layer BIL. The patterned preliminary supporting insulating layer pCO may be defined as the supporting insulating layer CO.

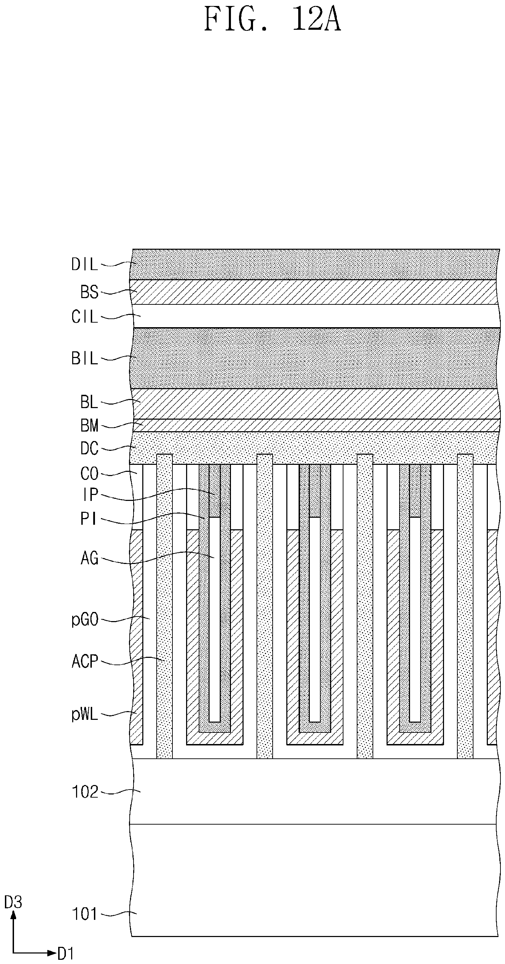

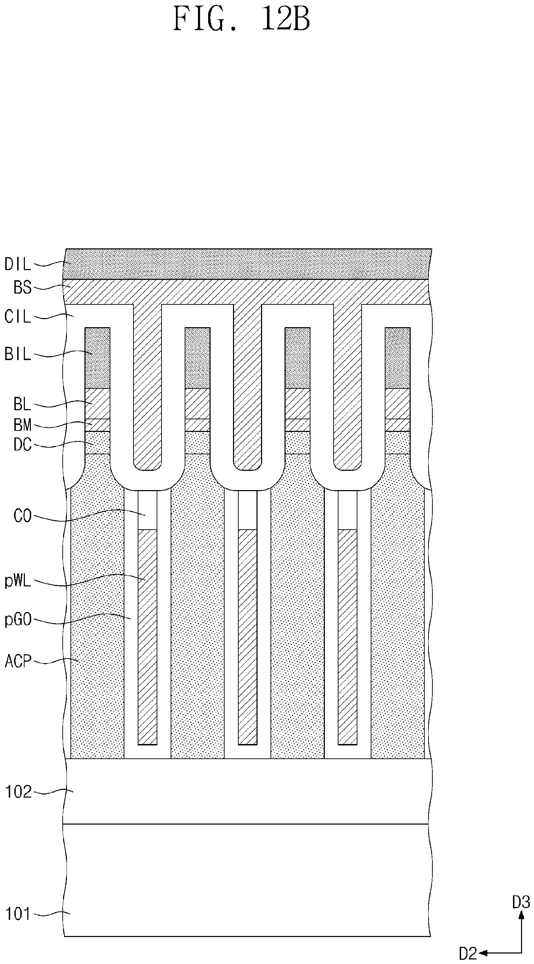

Referring to FIGS. 12A and 12B, the capping insulating layer CIL, the bit line protection layer BS, and the lower insulating layer DIL may be formed. The capping insulating layer CII, may be conformally formed on the connection layers DC, the barrier layers BM, the bit lines BL, and the bit line insulating layers BIL. The bit line protection layer BS may be formed on the capping insulating layer CIL. The lower insulating layer DIL may be formed on the bit line protection layer BS.

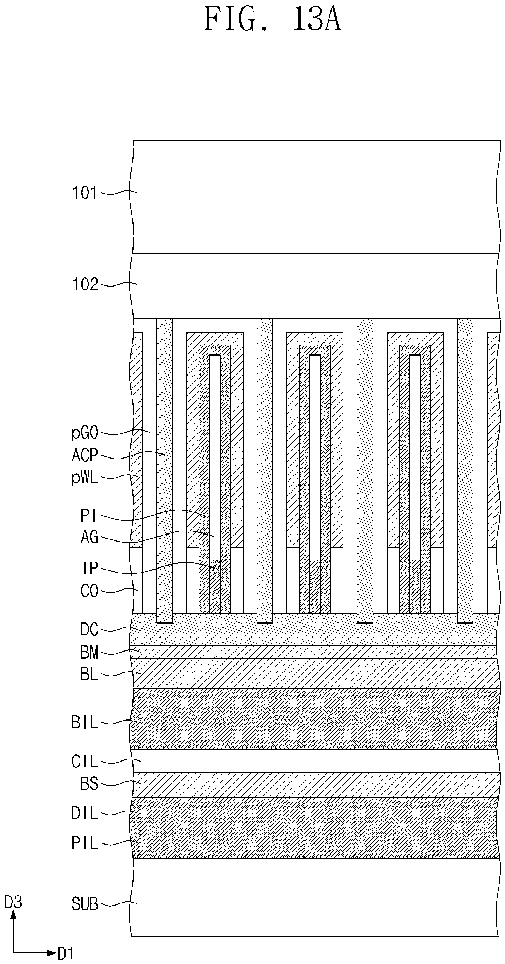

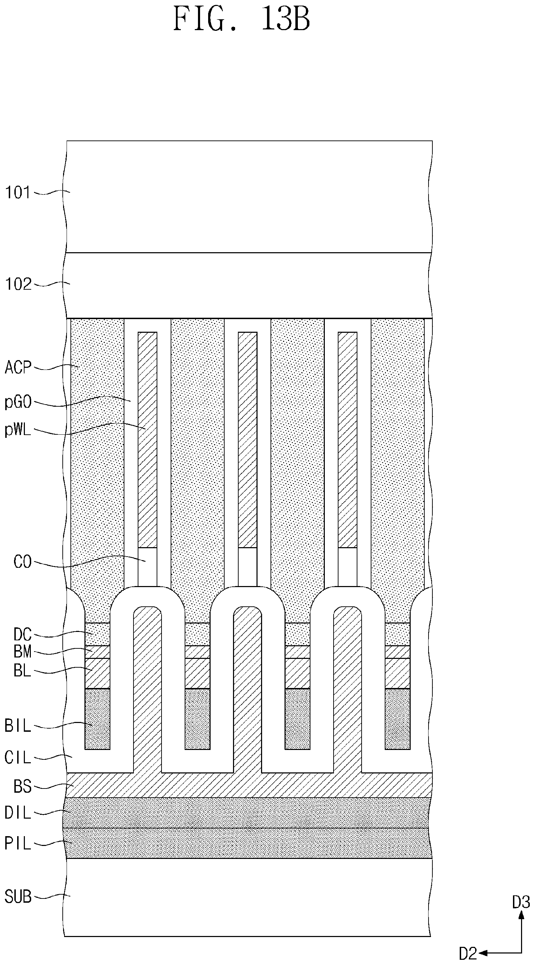

Referring to FIGS. 13A and 13B, the peripheral circuit insulating layer PIL may be formed on the substrate SUB. The wafer substrate 101 may be inverted. The lower insulating layer DIL may be bonded to the peripheral circuit insulating layer PIL. In some embodiments, the peripheral circuit insulating layer PIL and the lower insulating layer DIL may be bonded to each other using a wafer bonding process.

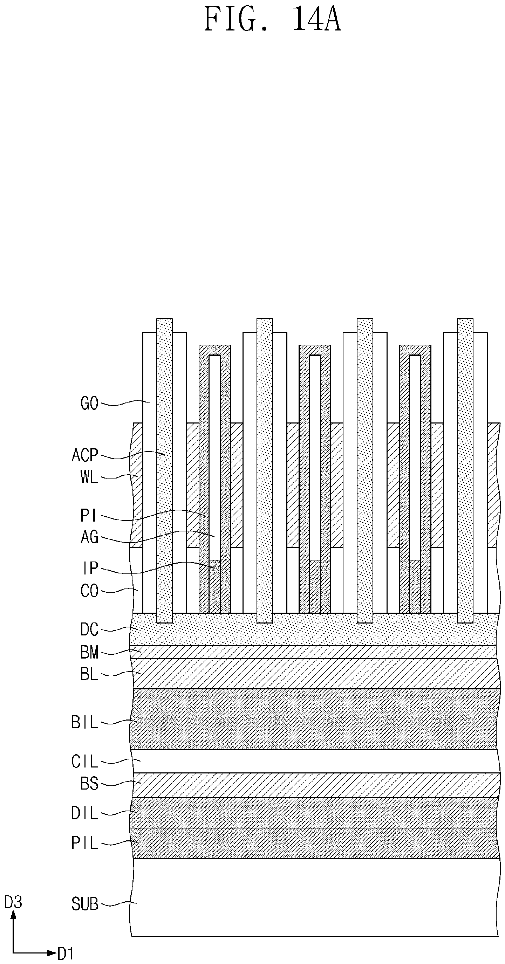

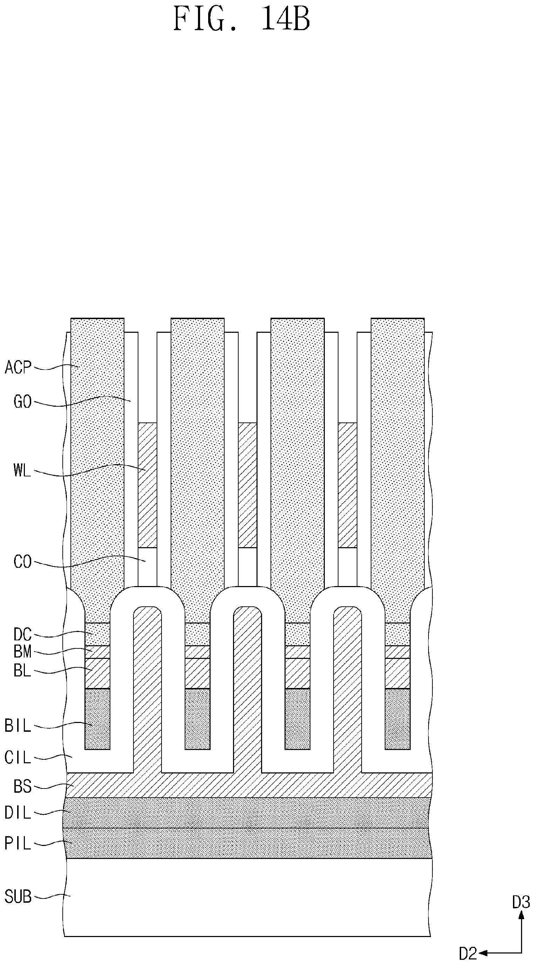

Referring to FIGS. 14A and 14B, the wafer substrate 101, the wafer insulating layer 102, portions of the preliminary gate insulating patterns pGO, and portions of the preliminary word lines pWL may be removed. As a result of the partial removal of the preliminary gate insulating patterns pGO and the preliminary word lines pWL, the gate insulating patterns GO and the word lines WL may be formed. As a result of the partial removal of the preliminary gate insulating patterns pGO and the preliminary word lines pWL, the protection patterns PI may be exposed to the outside. In some embodiments, the wafer substrate 101 and the wafer insulating layer 102 may be removed by a grinding process. In some embodiments, the partial removal of the preliminary gate insulating patterns pGO may be achieved through a wet etching process. In some embodiments, the partial removal of the preliminary word lines pWL may be achieved through an etch-back process.

Referring to FIGS. 2A, 2B, and 2C, the insulating structures IST may be formed. The insulating structure IST may be formed to fill an empty space that is formed by partially removing the preliminary word lines pWL.

The first upper insulating layer UIL1 may be formed on the active pillars ACP and the insulating structures IST. A process may be performed to remove a portion of the first upper insulating layer UIL1. The first data contact BC1 may be formed. The first data contact BC1 may be formed to fill an empty space, which is formed by removing the portion of the first upper insulating layer UIL1.

The second upper insulating layer UIL2 may be formed on the first upper insulating layer UIL1 and the first data contact BC1. A process may be performed to remove a portion of the second upper insulating layer UIL2. The second data contact BC2, the first landing pad LP1, and the second landing pad LP2 may be formed. The second data contact BC2, the first landing pad LP1, and the second landing pad LP2 may be formed to fill an empty space that is formed by removing the portion of the second upper insulating layer UIL2. The data storage patterns DSP may be formed to be connected to the second landing pads LP2, respectively.

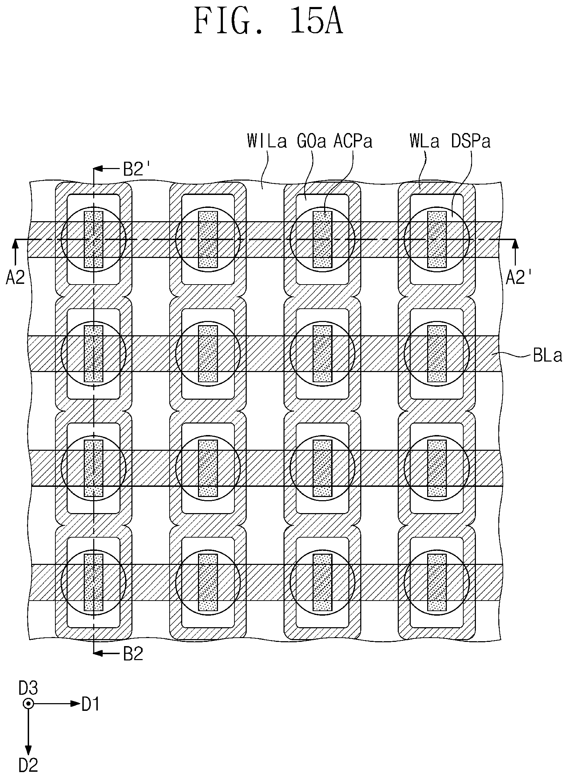

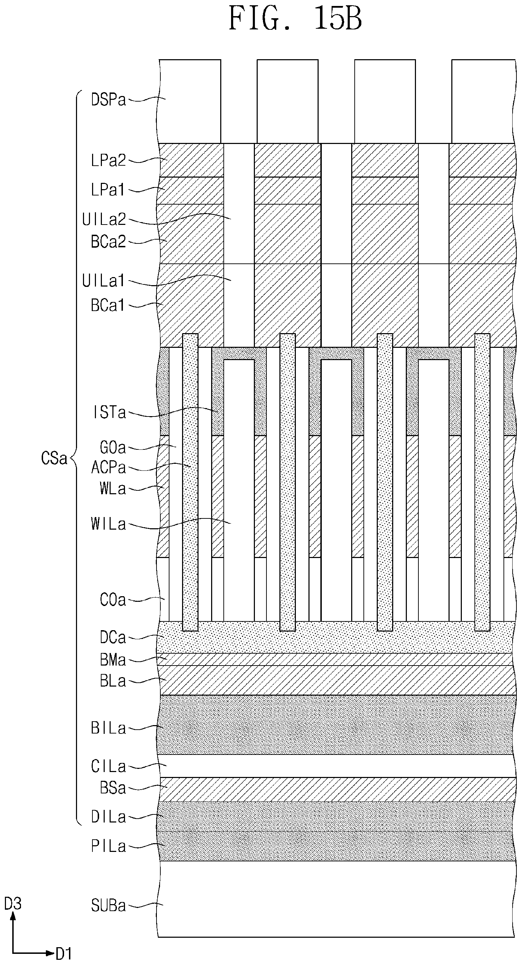

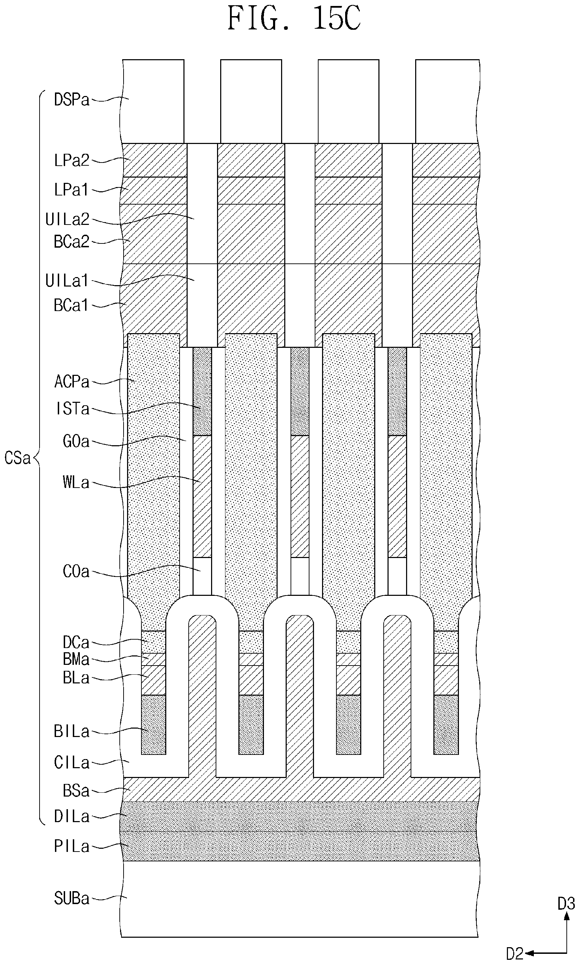

FIG. 15A is a plan view illustrating a semiconductor device according to some embodiments of the inventive concept. FIG. 15B is a sectional view taken along a line A2-A2' of FIG. 15A. FIG. 15C is a sectional view taken along a line B2-B2' of FIG. 15A.

Referring to FIGS. 15A, 15B, and 15C, the semiconductor device may include a connection layer DCa, word line insulating layers WILa, supporting insulating layers COa, word lines WLa, and insulating structures ISTa.

The word line insulating layers WILa may be disposed on the connection layer DCa. The word line insulating layer WILa may be extended in the second direction D2. The word line insulating layers WILa may be spaced apart from each other in the first direction D1.

The word line insulating layer WILa may be disposed between the supporting insulating layers COa and the word lines WLa. The word line insulating layer WILa may be in contact with the supporting insulating layers COa, the word lines WLa, and the insulating structure ISTa. The insulating structure ISTa may be disposed on the word lines WLa and the word line insulating layer WILa. The word line insulating layer WILa may be provided to separate adjacent ones of the word lines WLa from each other.

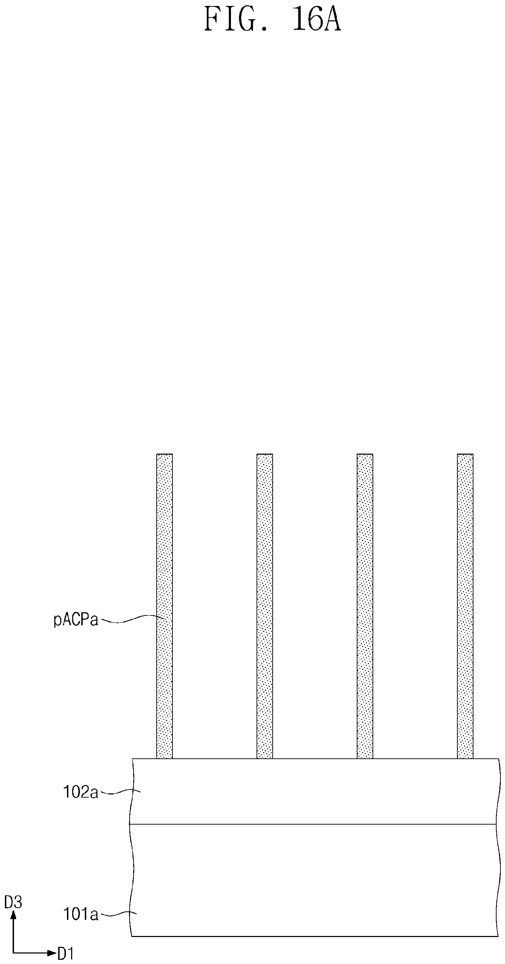

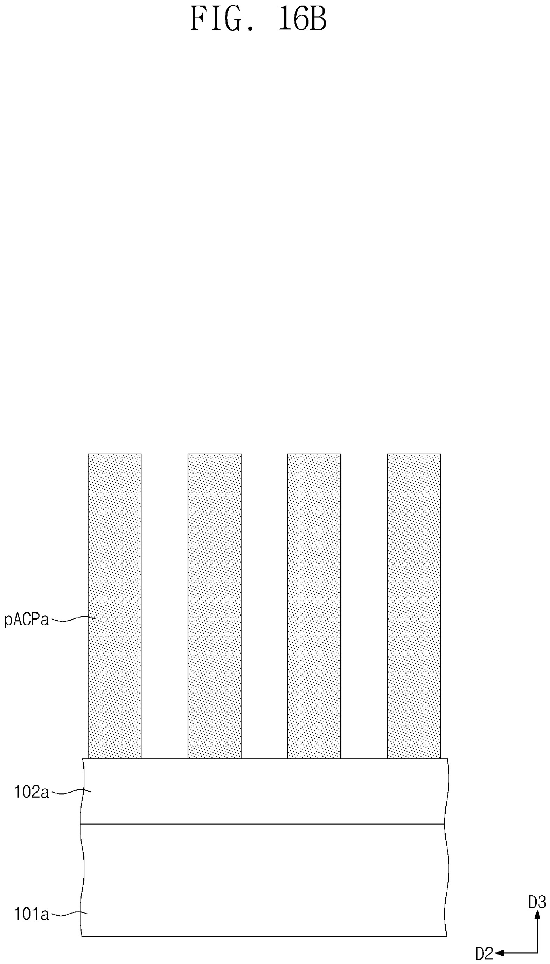

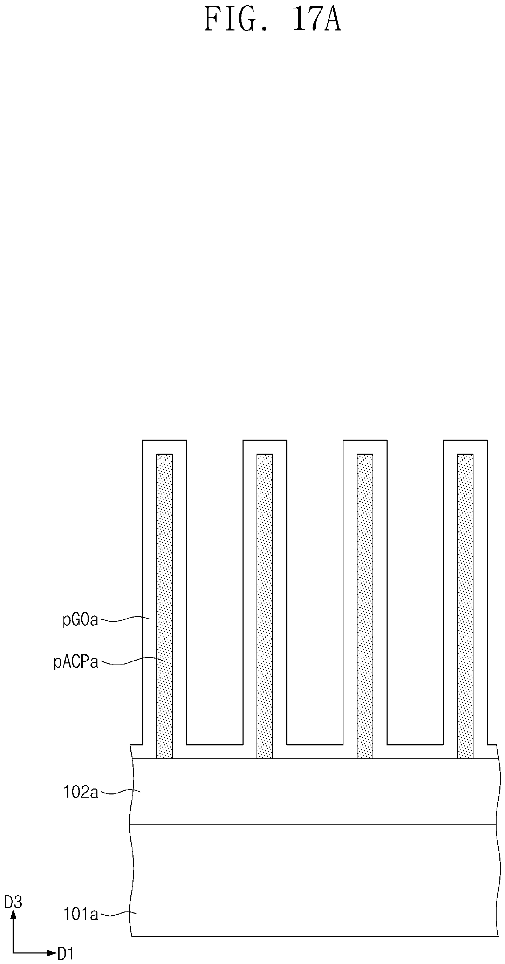

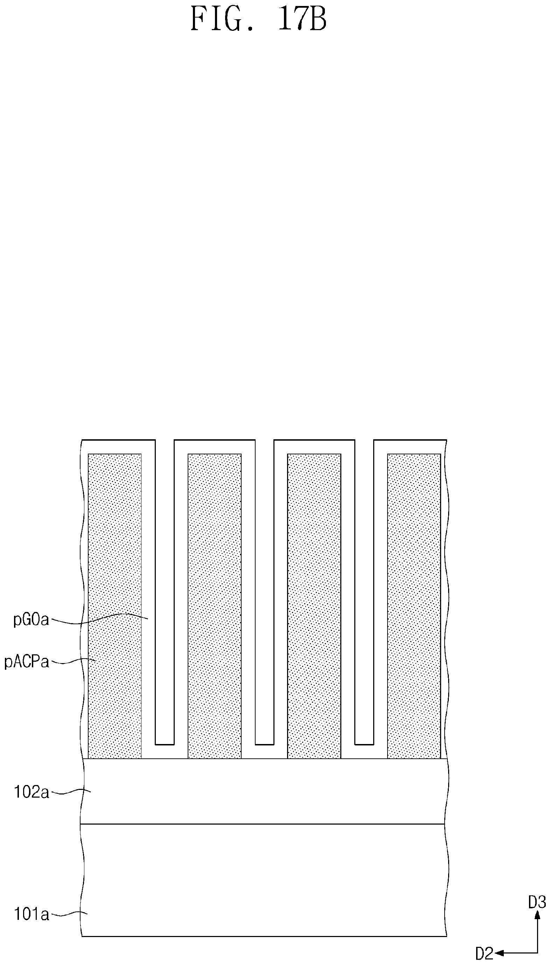

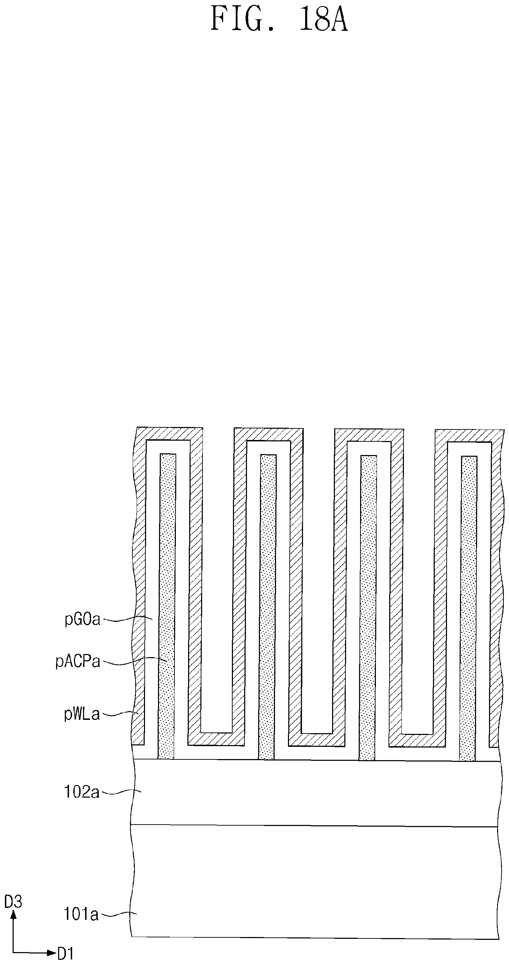

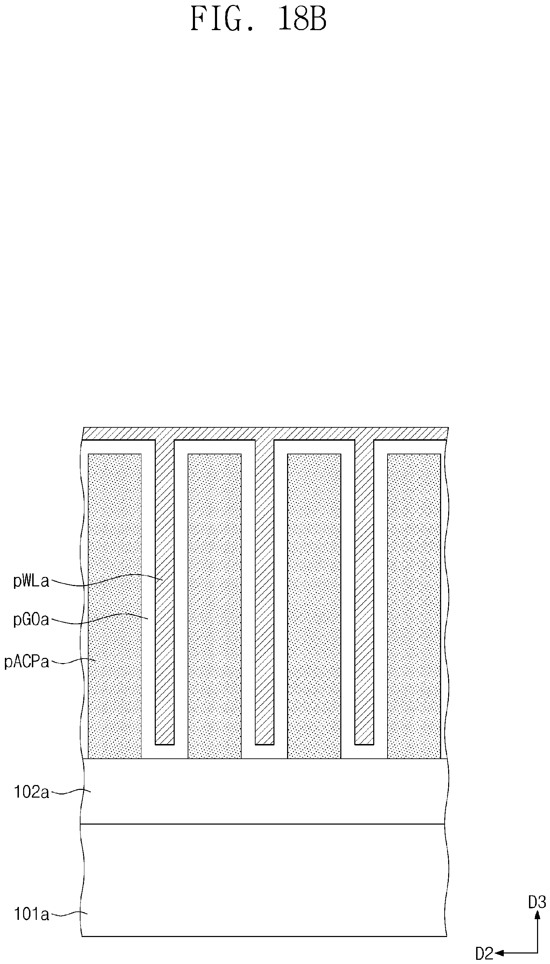

FIGS. 16A, 16B, 17A, 17B, 18A, 18B, 19A, 19B, 20A, 20B, 21A, 21B, 22A, 22B, 23A, and 23B are diagrams illustrating a method of fabricating a semiconductor device, according to some embodiments of the inventive concept. FIGS. 16A, 17A, 18A, 19A, 20A, 21A, 22A, and 23A illustrate a portion corresponding to FIG. 15B., FIGS. 16B, 17B, 18B, 19B, 20B, 21B, 22B, and 23B illustrate a portion corresponding to FIG. 15C.

Referring to FIGS. 16A, 16B, 17A, 17B, 18A, and 18B, a wafer substrate 101a, a wafer insulating layer 102a, preliminary active pillars pACPa, preliminary gate insulating patterns pGOa, and preliminary word lines pWLa may be formed in a manner similar to that described with reference to FIGS. 3A, 3B, 4A, 4B, 5A, and 5B.

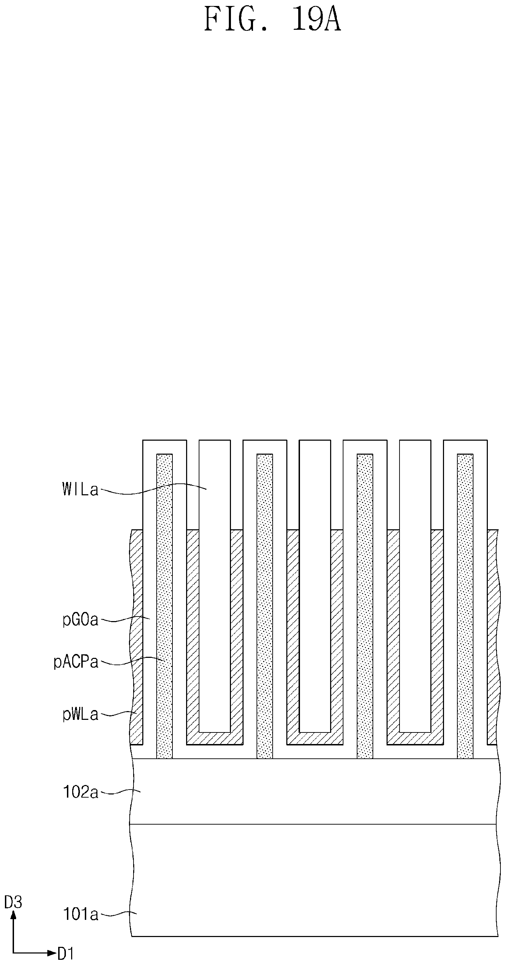

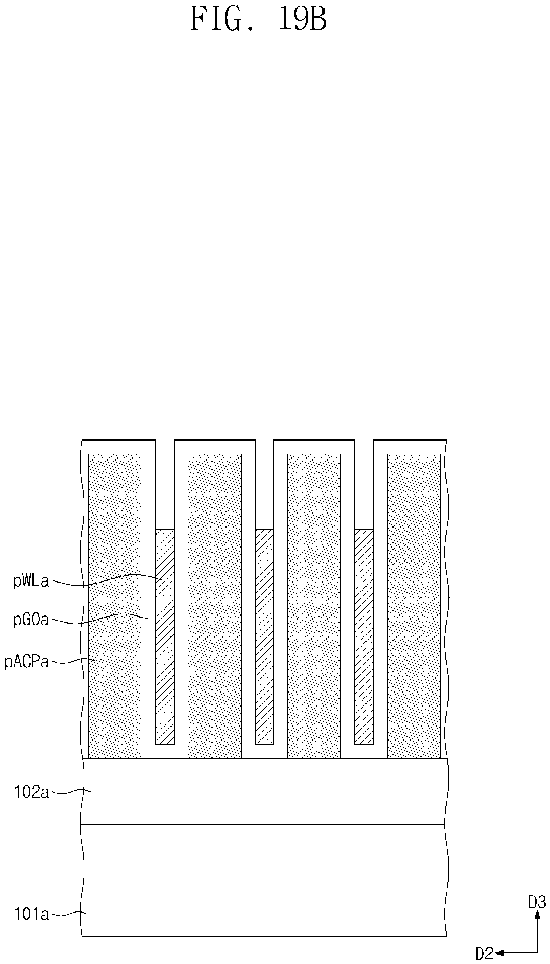

Referring to FIGS. 19A and 19B, the word line insulating layers WILa may be formed. The word line insulating layers WILa on the preliminary word line pWLa may be formed between the preliminary active pillars pACPa. After the formation of the word line insulating layers WILa, a portion of the preliminary word line pWL may be removed. As a result of the partial removal of the preliminary word line pWL, the preliminary gate insulating pattern pGOa may be exposed to the outside. In some embodiments, the partial removal of the preliminary word line pWL may be achieved by an etch-back process.

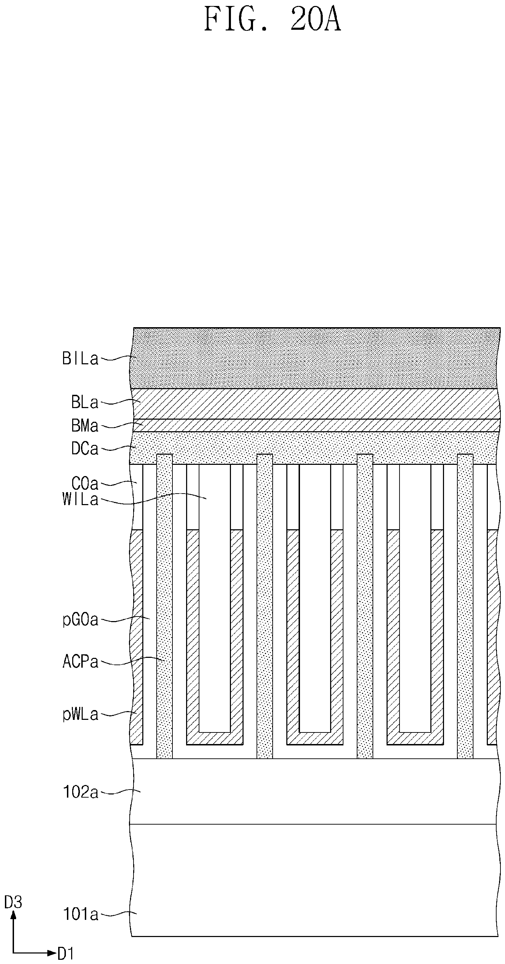

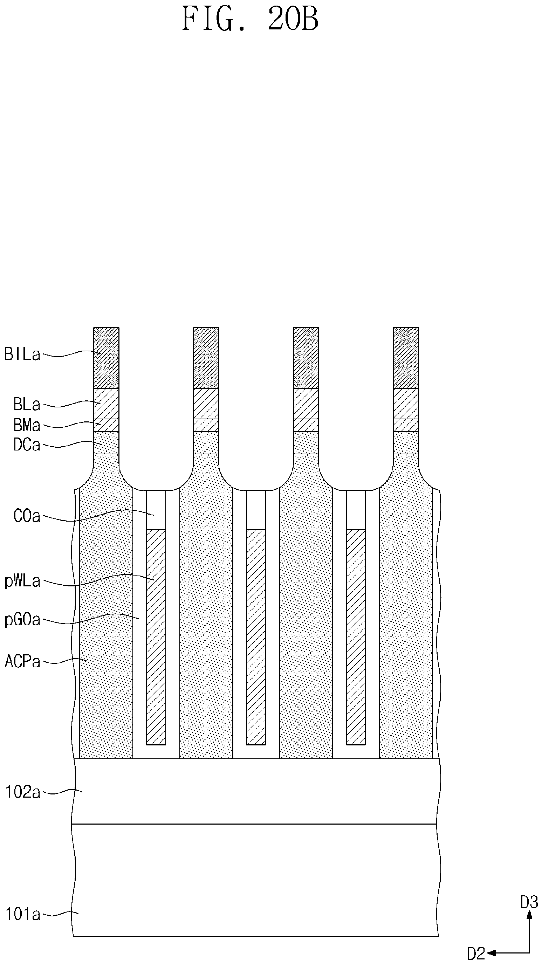

Referring to FIGS. 20A and 20B, the supporting insulating layers COa, the connection layers DCa, barrier layers BMa, bit lines BLa, and bit line insulating layers BILa may be formed. The supporting insulating layers COa, the connection layers DCa, the barrier layers BMa, the bit lines BLa, and the bit line insulating layers BILa may be formed using a method that is similar to the method of forming the supporting insulating layers CO, the connection layers DC, the barrier layers BM, the bit lines BL, and the bit line insulating layers BIL, described with reference to FIGS. 11A and 11B.

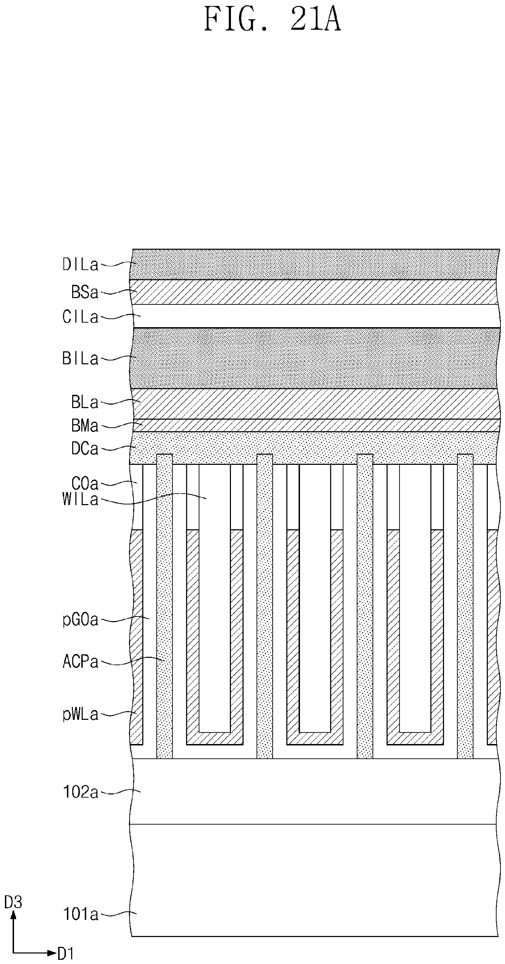

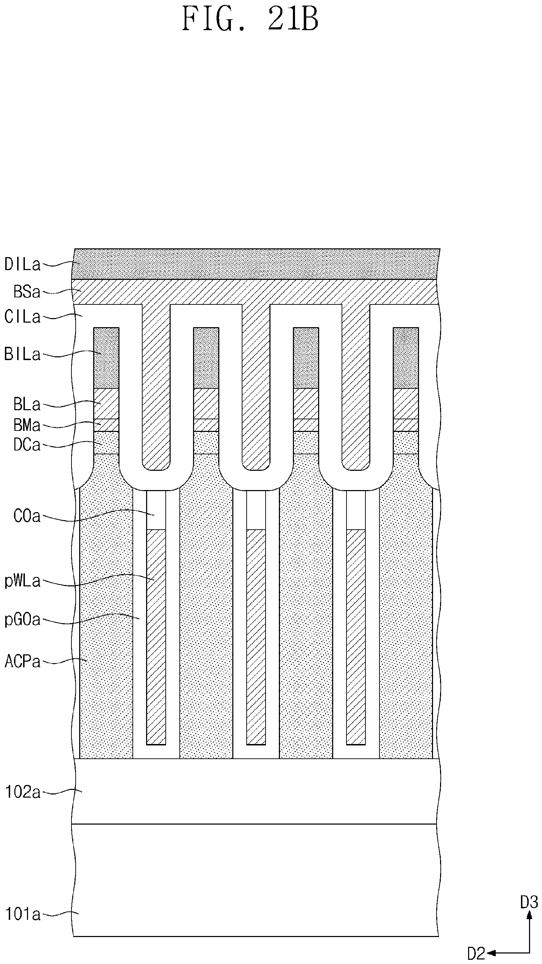

Referring to FIGS. 21A and 21B, a capping insulating layer CILa, a bit line protection layer BSa, and a lower insulating layer DILa may be formed. The capping insulating layer CILa, the bit line protection layer BSa, and the lower insulating layer DILa may be formed using a method that is similar to the method of forming the capping insulating layer CIL, the bit line protection layer BS, and the lower insulating layer DIL, described with reference to FIGS. 12A and 12B.

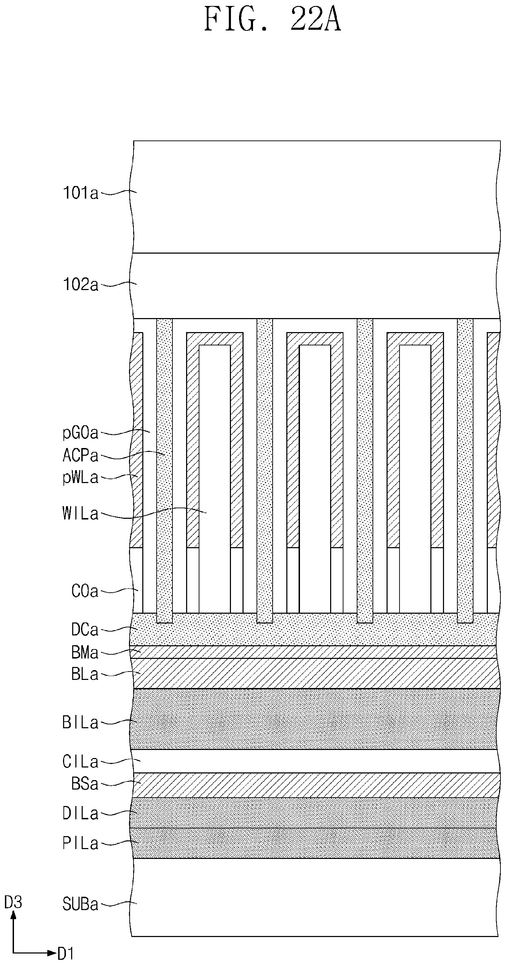

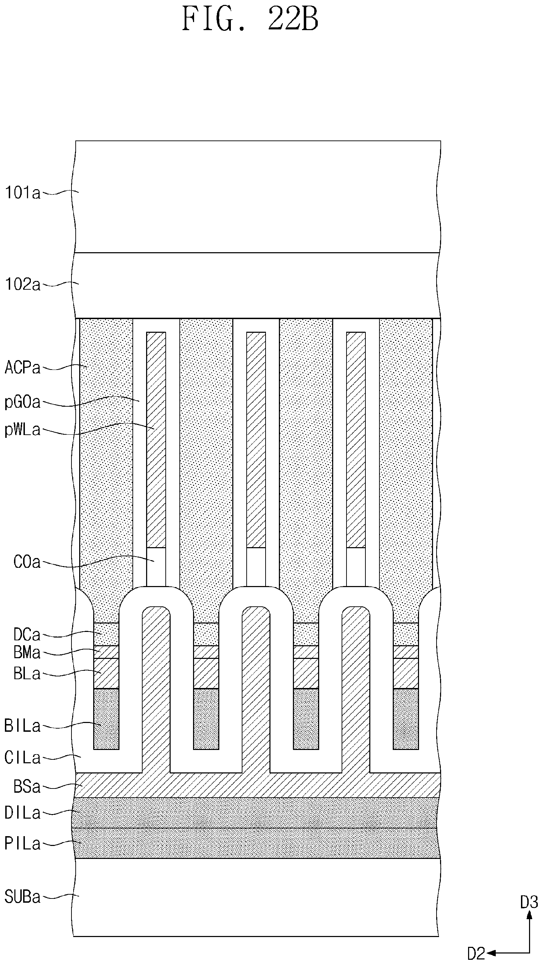

Referring to FIGS. 22A and 22B, a substrate SUBa and a peripheral circuit insulating layer PILa on the substrate SUBa may be formed. The lower insulating layer DILa may be bonded to the peripheral circuit insulating layer PILa. In some embodiments, the peripheral circuit insulating layer PILa and the lower insulating layer DILa may be bonded to each other by a wafer bonding process.

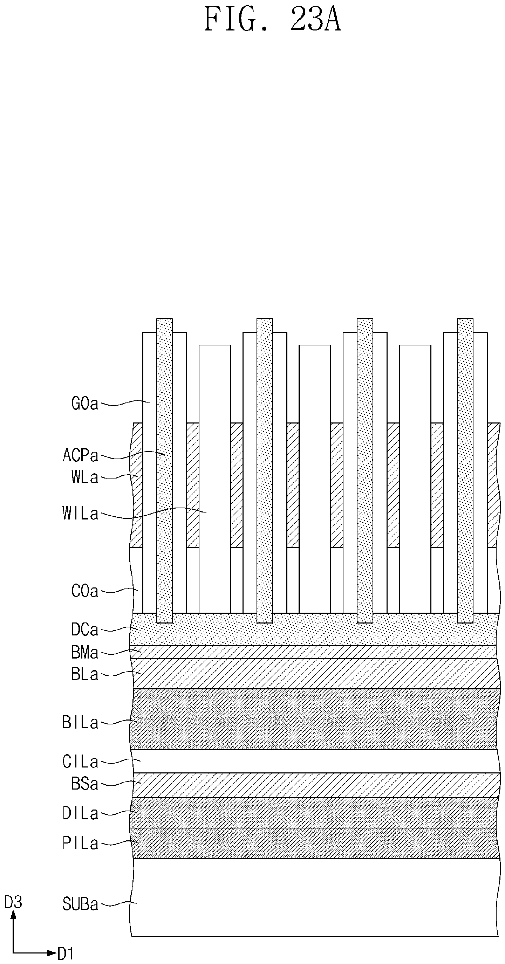

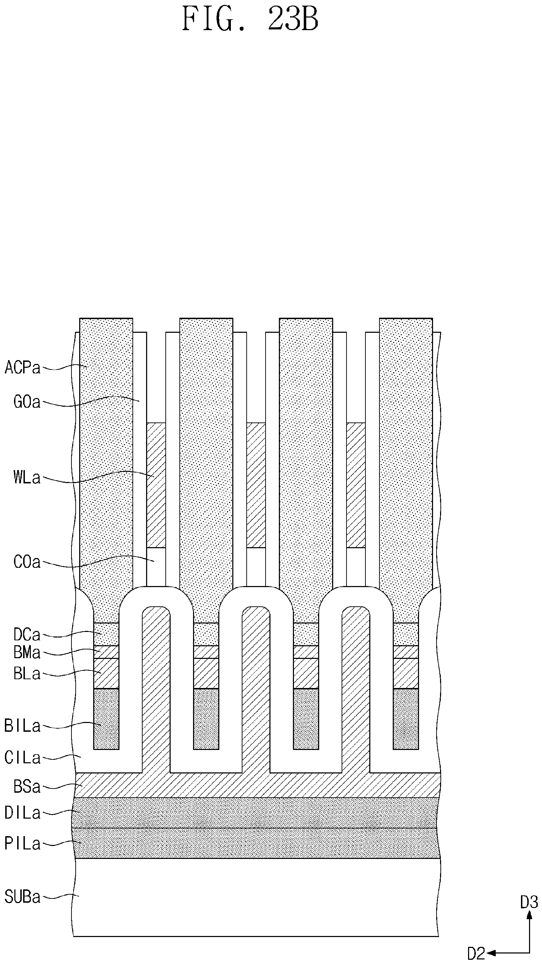

Referring to FIGS. 23A and 23B, the wafer substrate 101a, the wafer insulating layer 102a, portions of the preliminary gate insulating patterns pGOa, and portions of the preliminary word lines pWLa may be removed. As a result of the partial removal of the preliminary gate insulating patterns pGOa and the preliminary word lines pWLa, the gate insulating patterns GOa and the word lines WLa may be formed. As a result of the partial removal of the preliminary gate insulating patterns pGOa and the preliminary word lines pWLa, upper portions of the word line insulating layers WILa may be exposed to the outside.

Referring to FIGS. 15B and 15C, the insulating structures ISTa, a first upper insulating layer UILa1, a second upper insulating layer UILa2, first data contacts BCa1, second data contacts BCa2, first landing pads LPa1, second landing pads LPa2, and the data storage patterns DSPa may be formed. The insulating structure ISTa, the first upper insulating layer UILa1, the second upper insulating layer UILa2, the first data contact BCa1, the second data contact BCa2, the first landing pad LPa1, the second landing pad LPa2, and the data storage pattern DSPa may be formed using a method that is similar to the method of forming the insulating structures IST, the first upper insulating layer UIL1, the second upper insulating layer UIL2, the first data contact BC1, the second data contact BC2, the first landing pad LP1, the second landing pad LP2, and the data storage pattern DSP, described with reference to FIGS. 2B and 2C.

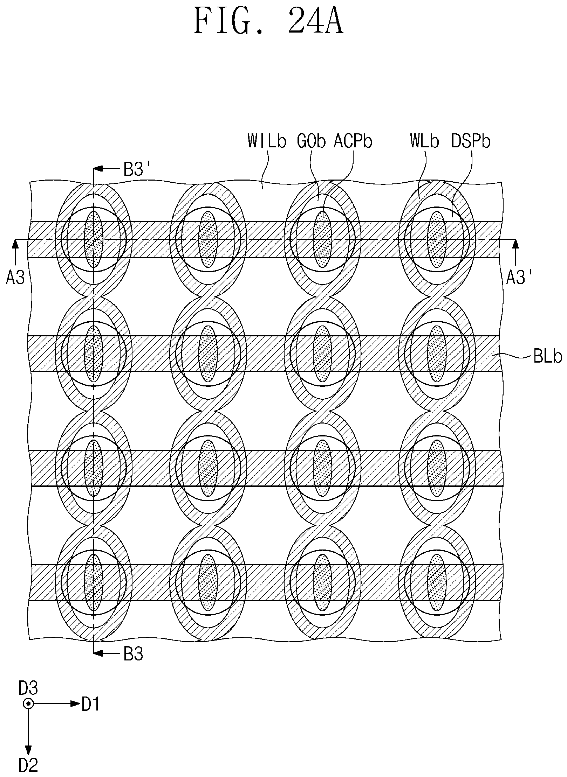

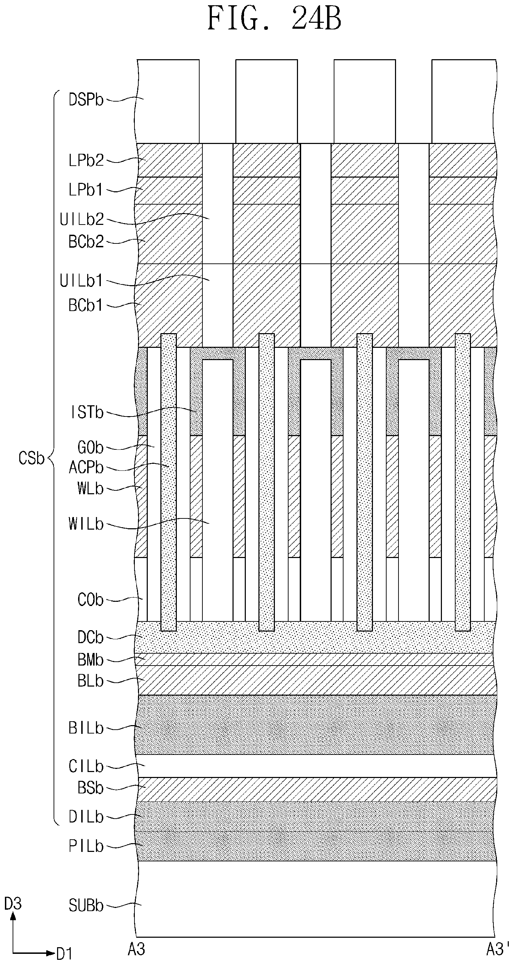

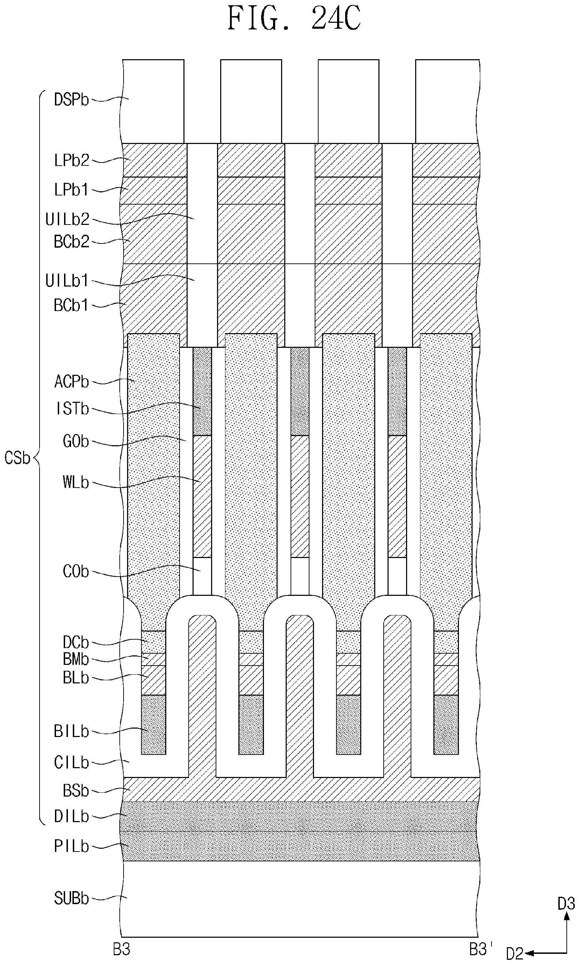

FIG. 24A is a plan view illustrating a semiconductor device according to some embodiments of the inventive concept. FIG. 24B is a sectional view taken along a line A3-A3' of FIG. 24A. FIG. 24C is a sectional view taken along a line B3-B3' of FIG. 24A.

Referring to FIGS. 24A, 24B, and 24C, the semiconductor device may include active pillars ACPb, gate insulating patterns GOb, word lines WLb, and word line insulating layers WILb.

Each of the active pillars ACPb may have an elliptical shape. A width of the active pillar ACPb in the first direction D1 may be smaller than a width in the second direction D2. Each of the gate insulating patterns GOb may have an elliptical shape. A width of a gate insulating pattern Gob in the first direction D1 may be smaller than a width in the second direction D2. The word line WLb may be provided to conformally enclose the gate insulating patterns GOb arranged in the second direction D2. Inner and outer side surfaces of the word line WLb may have a curved or uneven shape.

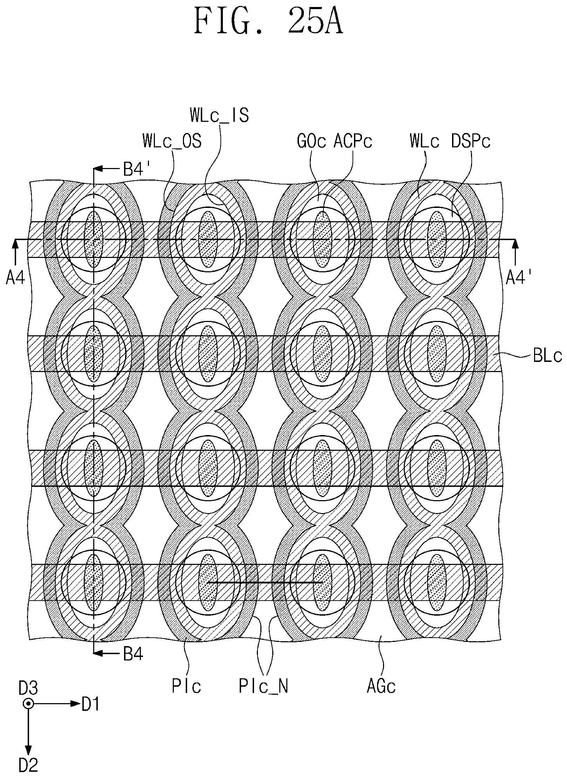

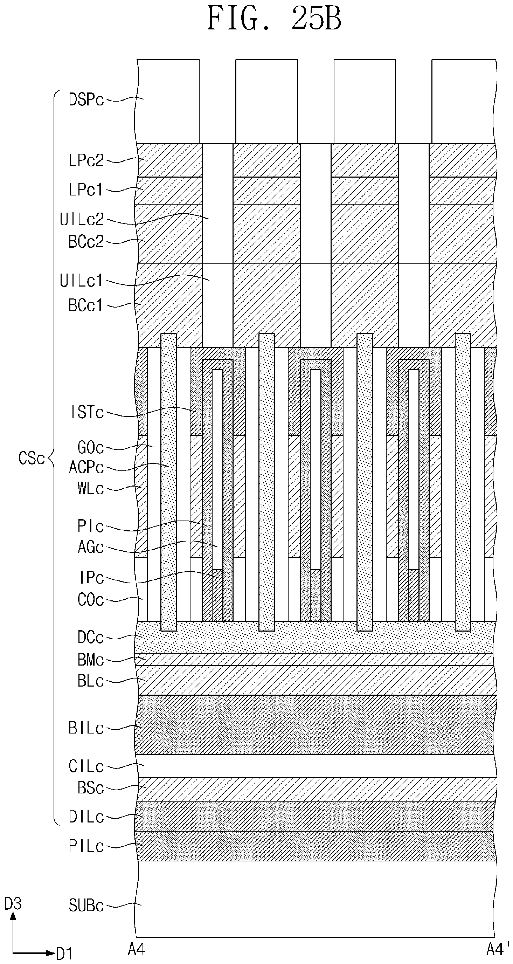

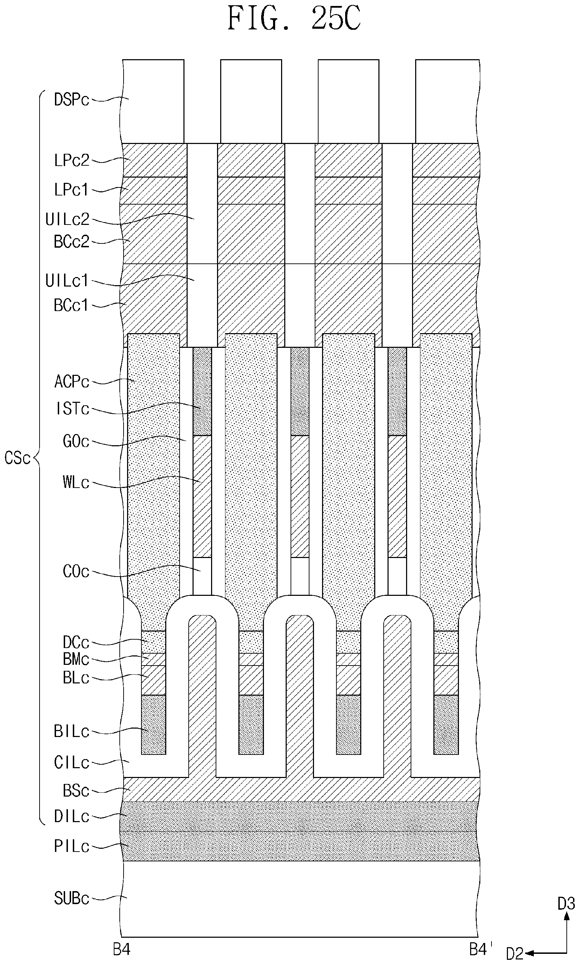

FIG. 25A is a plan view illustrating a semiconductor device according to some embodiments of the inventive concept. FIG. 25B is a sectional view taken along a line A4-A4' of FIG. 25A. FIG. 25C is a sectional view taken along a line B4-B4' of FIG. 25A.

Referring to FIGS. 25A, 25B, and 25C, the semiconductor device may include active pillars ACPc, gate insulating patterns GOc, bit lines BLc, word lines WLc, and protection patterns PIc.

Each of the active pillars ACPc may have an elliptical shape. A width of the active pillar ACPc in the first direction D1 may be smaller than a width in the second direction D2. Each of the gate insulating patterns GOc may have an elliptical shape. A width of the gate insulating pattern GOc in the first direction D1 may be smaller than a width in the second direction D2.

The word line WLc may be provided to conformally enclose the gate insulating patterns GOc, which are adjacent to each other in the second direction D2. The word line WLc may include an inner side surface WLc_IS in contact with the gate insulating pattern GOc and an outer side surface WLc_OS in contact with the protection pattern PIc. The inner and outer side surfaces WLc_IS and WLc_OS of the word line WLc may have a curved or uneven shape.

The protection patterns PIc may be provided to conformally enclose the word lines WLc. The protection pattern PIc may include an exposed surface PIc_N. The exposed surface PIc_N of the protection pattern PIc may define the air gap AGc. The exposed surface PIc_N of the protection pattern PIc may have a curved or uneven shape. A width of the air gap AGc in the first direction D1 may increase as a distance from the bit line BL increases.

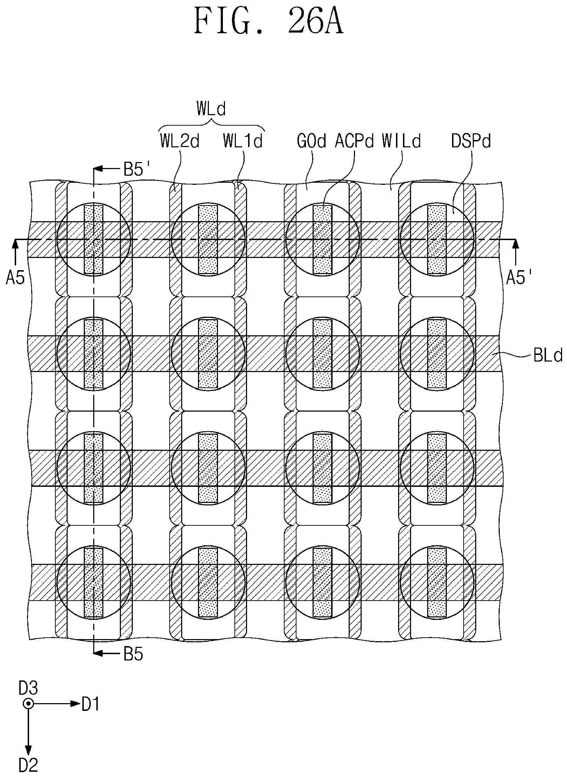

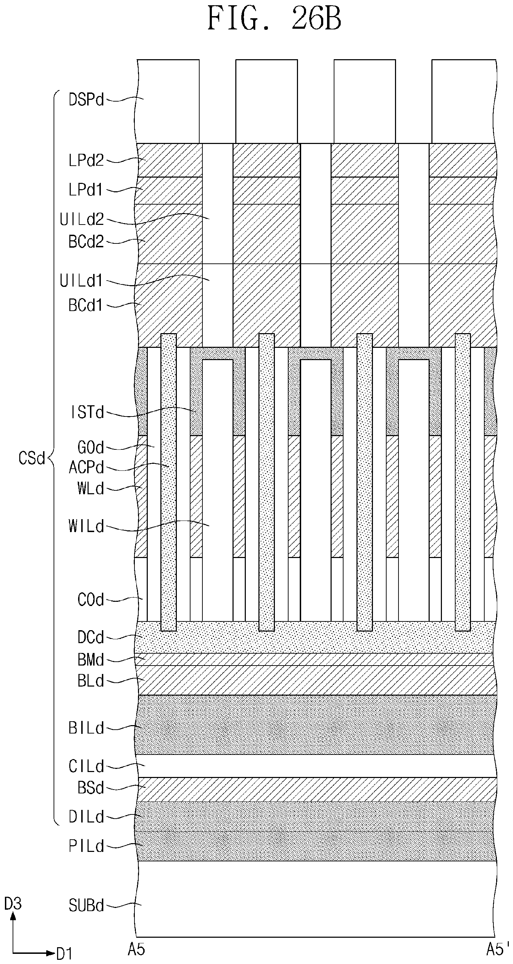

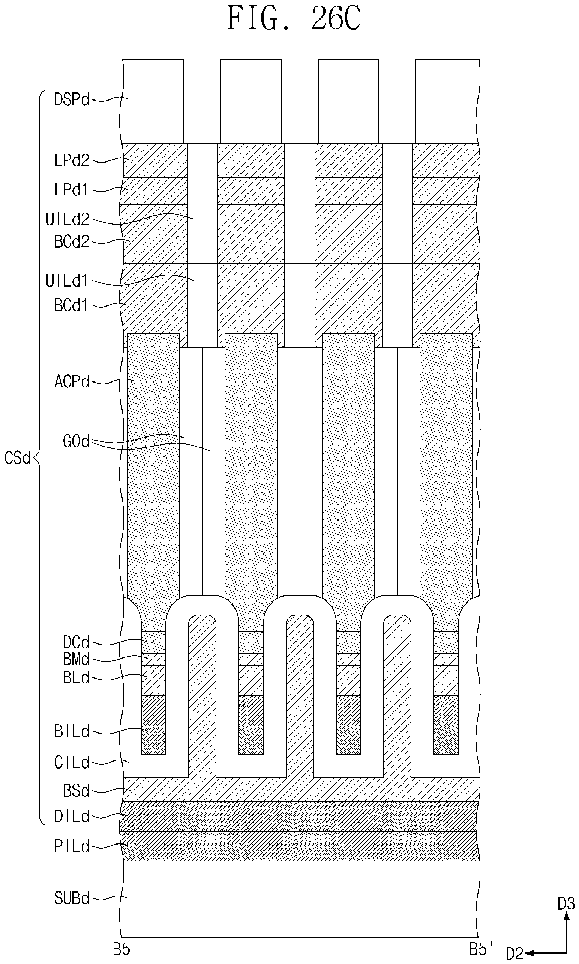

FIG. 26A is a plan view illustrating a semiconductor device according to some embodiments of the inventive concept. FIG. 26B is a sectional view taken along a line A5-A5' of FIG. 26A. FIG. 26C is a sectional view taken along a line B5-B5' of FIG. 26A.

Referring to FIGS. 26A, 26B, and 26C, the semiconductor device may include active pillars ACPd, gate insulating patterns GOd, word lines WLd, and word line insulating layers WILd.

Each of the gate insulating patterns GOd may enclose each of the active pillars ACPd. The gate insulating patterns GOd, which are adjacent to each other in the second direction D2, may be in contact with each other. The word line WLd may not be interposed between the gate insulating patterns GOd, which are adjacent to each other in the second direction D2.

The word lines WLd may include a first word line WL1d and a second word line WL2d, which are spaced apart from each other in the first direction D1. The gate insulating pattern GOd may be disposed between the first and second word lines WL1d and WL2d. The word line insulating layer WILd may be disposed between the first and second word lines WL1d and WL2d. The first and second word lines WL1d and WL2d may be alternatingly disposed, with the gate insulating pattern GOd or the word line insulating layer WILd interposed therebetween.

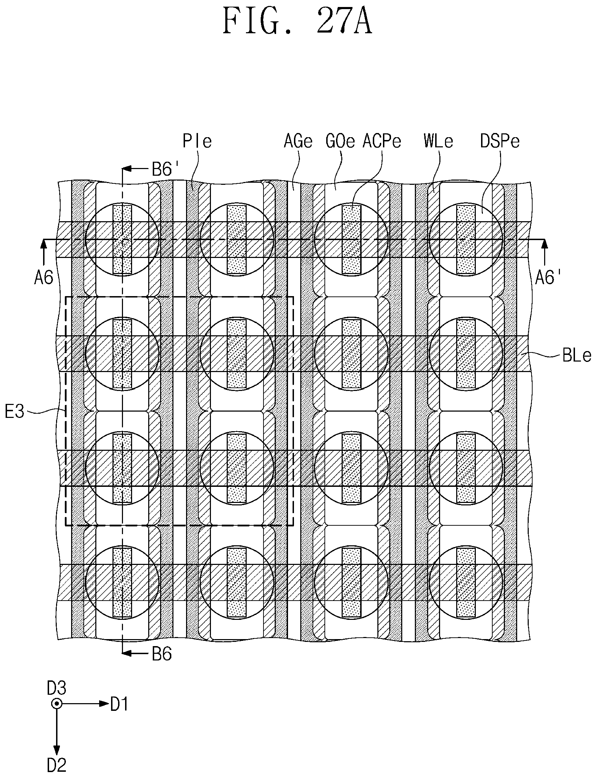

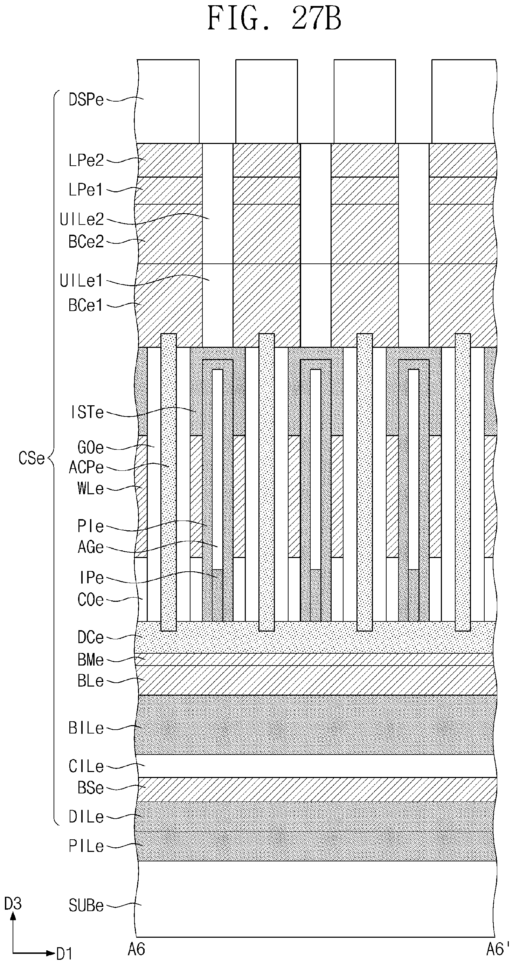

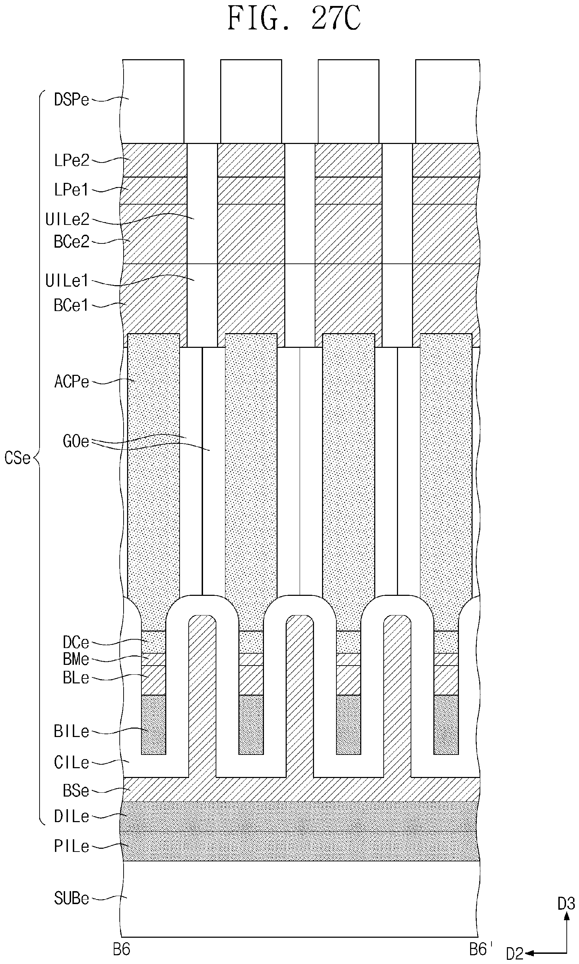

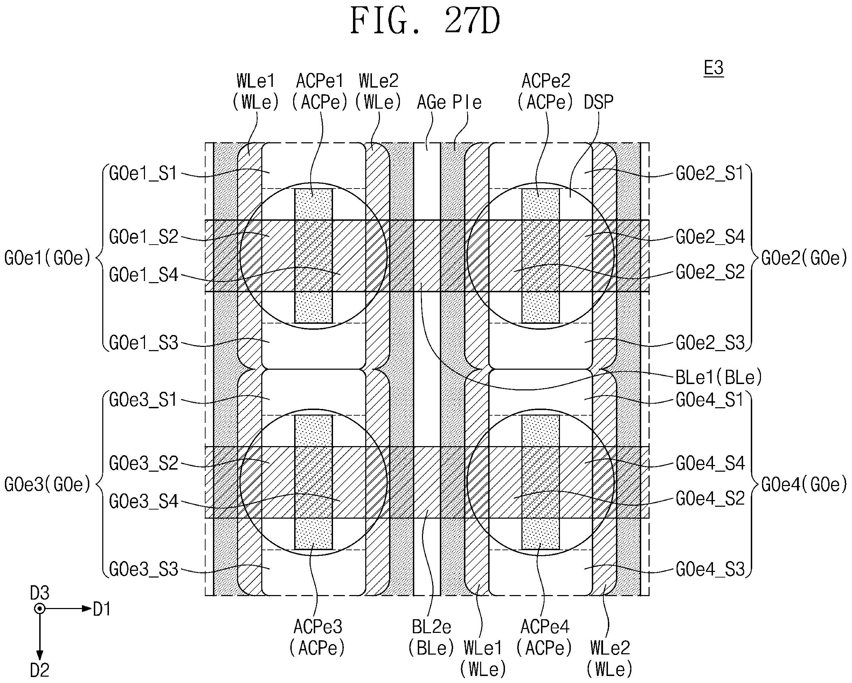

FIG. 27A is a plan view illustrating a semiconductor device according to some embodiments of the inventive concept. FIG. 27B is a sectional view taken along a line A6-A6' of FIG. 27A. FIG. 27C is a sectional view taken along a line B6-B6' of FIG. 27A. FIG. 27D is an enlarged view illustrating a portion E3 of FIG. 27A.

Referring to FIGS. 27A, 27B, 27C, and 27D, the semiconductor device may include active pillars ACPe, gate insulating patterns GOe, bit lines BLe, word lines WLe, and protection patterns PIe.

The bit lines BLe may include a first bit line BLe1 and a second bit line BLe2. The word lines WLe may include a first word line WLe1 and a second word line WLe2. The active pillars ACPe may include a first active pillar ACPe1, a second active pillar ACPe2, a third active pillar ACPe3 and a fourth active pillar ACPe4. The gate insulating patterns GOe may include a first gate insulating pattern GOe1, a second gate insulating pattern GOe2, a third gate insulating pattern GOe3, and a fourth gate insulating pattern GOe4.

The first to fourth gate insulating patterns GOe1, GOe2, GOe3, and GOe4 may be provided to enclose the first to fourth active pillars ACP1, ACP2, ACP3, and ACP4, respectively. The first to fourth gate insulating patterns GOe1, GOe2, GOe3, and GOe4 may include first sidewalls GOe1_S1, GOe2_S1, GOe3_S1, and GOe4_S1, second sidewalls GOe1_S2, GOe2_S2, GOe3_S2, and GOe4_S2, third sidewalls GOe1_S3, GOe2_S3, GOe3_S3, and GOe4_S3, and fourth sidewalls GOe1_S4, GOe2_S4, GOe3_S4, and GOe4_S4, respectively.

The third sidewall GOe1_S3 of the first gate insulating pattern GOe1 may be in contact with the first sidewall GOe3_S1 of the third gate insulating pattern GOe3. The word line WLe may not be interposed between the third sidewall GOe1_S3 of the first gate insulating pattern GOe1 and the first sidewall GOe3_S1 of the third gate insulating pattern GOe3. The third sidewall GOe2_S3 of the second gate insulating pattern GOe2 may be in contact with the first sidewall GOe4_S1 of the fourth gate insulating pattern GOe4. The word line WLe may not be interposed between the third sidewall GOe2_S3 of the second gate insulating pattern GOe2 and the first sidewall GOe4_S1 of the fourth gate insulating pattern GOe4.

The gate insulating patterns GOe may be disposed between the first and second word lines WLe1 and WLe2. The first and second word lines WLe1 and WLe2 may be alternatingly disposed, with the gate insulating pattern GOe or the protection pattern PIe interposed therebetween.

In some embodiments, the first gate insulating pattern GOe1 and the third gate insulating pattern GOe3 may be connected to each other without any interface therebetween to form a single object, and the second gate insulating pattern GOe2 and the fourth gate insulating pattern GOe4 may be connected to each other without any interface therebetween to form a single object.

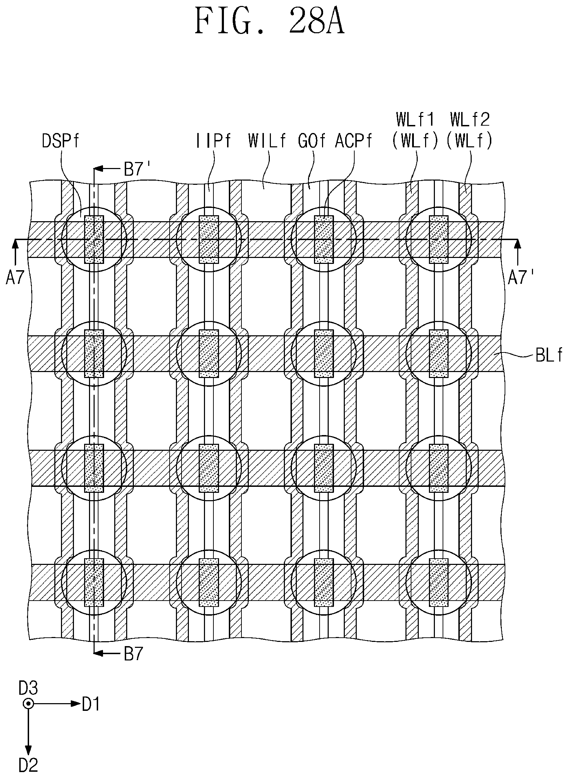

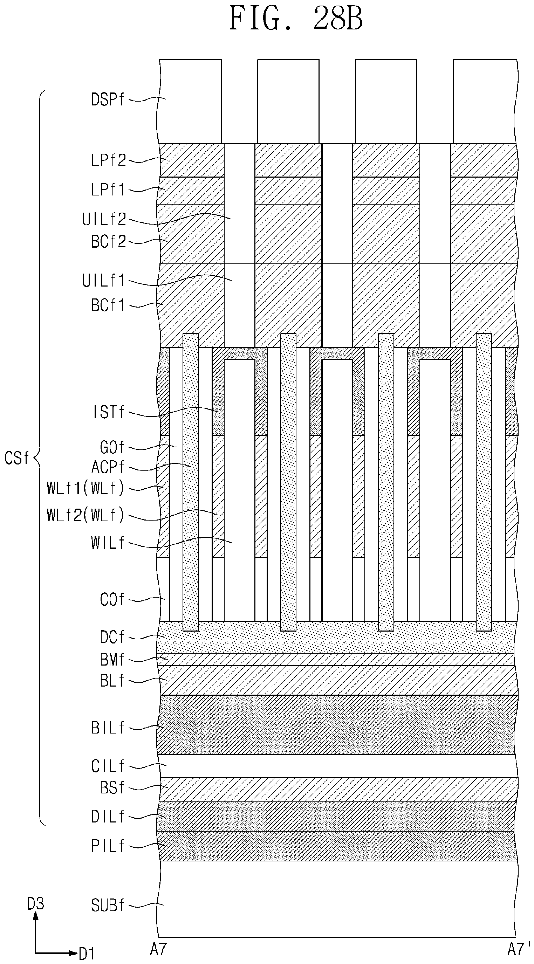

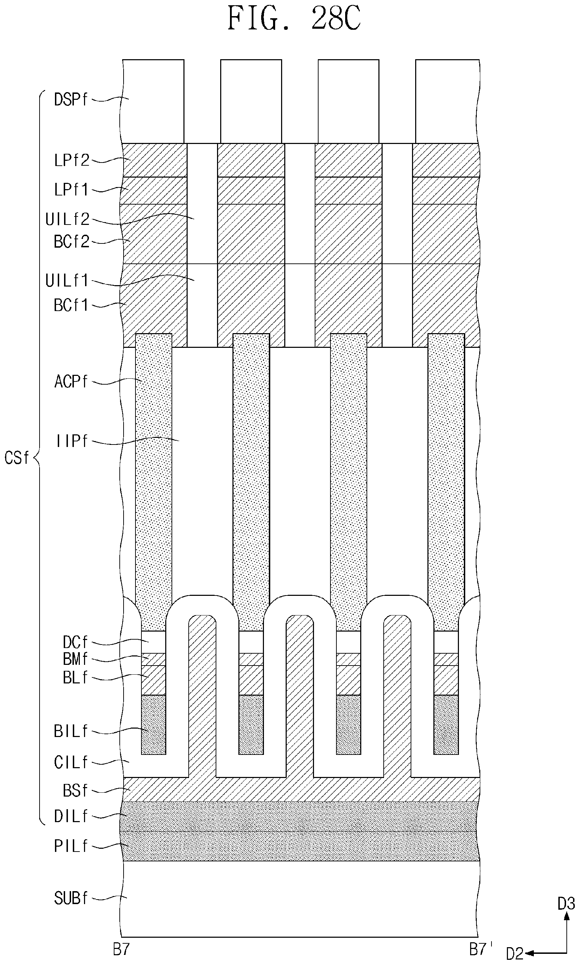

FIG. 28A is a plan view illustrating a semiconductor device according to some embodiments of the inventive concept. FIG. 28B is a sectional view taken along a line A7-A7' of FIG. 28A. FIG. 28C is a sectional view taken along a line B7-B7' of FIG. 28A.

Referring to FIGS. 28A, 28B, and 28C, the semiconductor device may further include active pillars ACPf, gate insulating patterns GOf, word lines WLf, and word line insulating layers WILf. The semiconductor device may further include insulating pillars IIPf between the active pillars ACPf.

The insulating pillars IIPf may be arranged to be spaced apart from each other in the second direction D2, with the active pillars ACPf interposed therebetween. The insulating pillar IIPf may be in contact with adjacent ones of the active pillars ACPf. The gate insulating pattern GOf may enclose the active pillars ACPf and the insulating pillars IIPf, which are arranged in the second direction D2. A width of the insulating pillar IIPf in the first direction D1 may be smaller than a width of the active pillar ACPf in the first direction D1.

The word lines WLf may include a first word line WL1f and a second word line WL2f, which are spaced apart from each other in the first direction D1. The gate insulating pattern GOf may be disposed between the first and second word lines WL1f and WL2f. The word line insulating layer WILf may be disposed between the first and second word lines WL1f and WL2f. The first and second word lines WL1f and WL2f may be alternatingly disposed, with the gate insulating pattern GOf or the word line insulating layer WILf interposed therebetween.

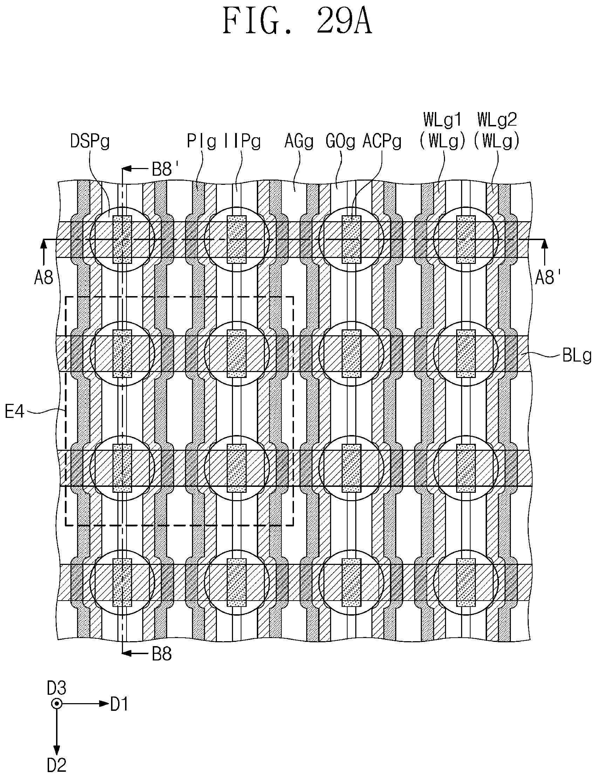

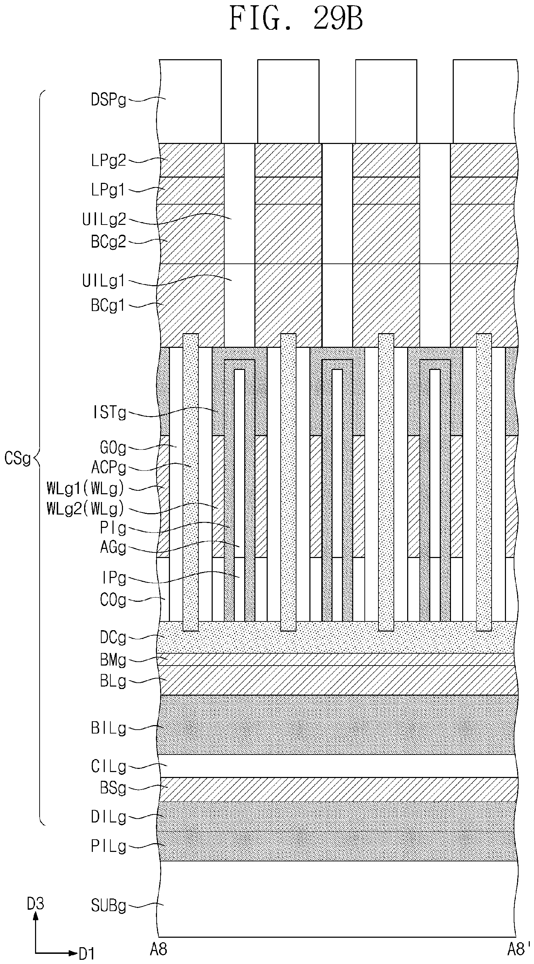

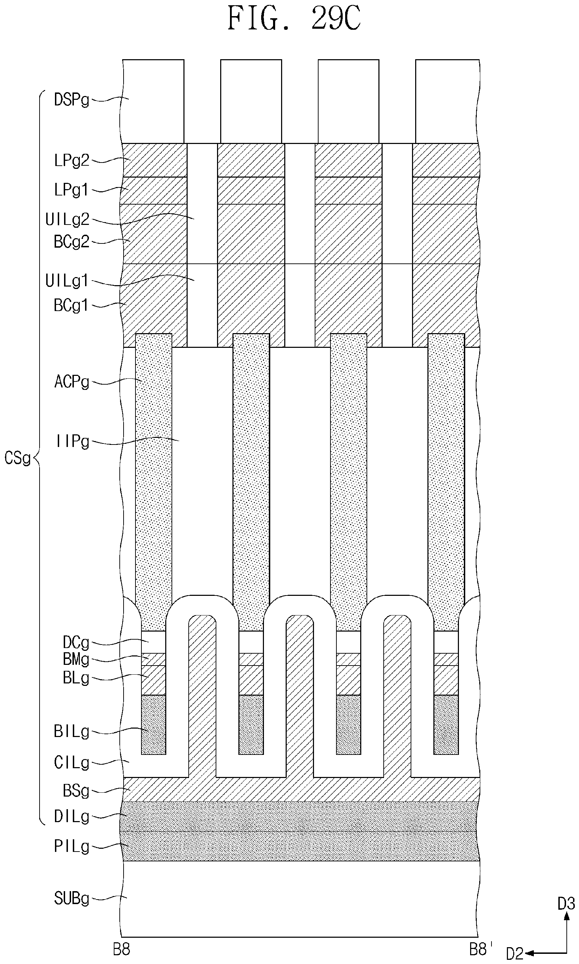

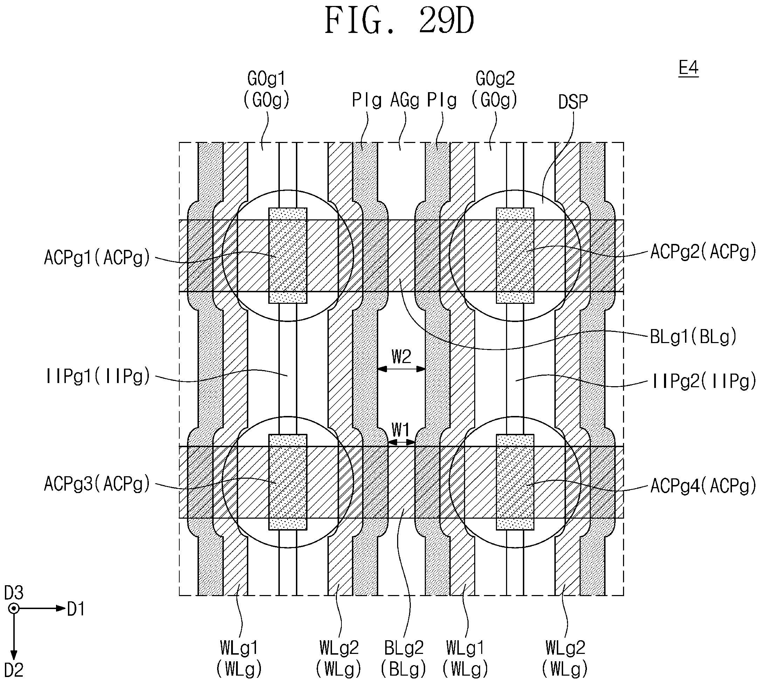

FIG. 29A is a plan view illustrating a semiconductor device according to some embodiments of the inventive concept. FIG. 29B is a sectional view taken along a line A8-A8' of FIG. 29A. FIG. 29C is a sectional view taken along a line B8-B8' of FIG. 29A. FIG. 29D is an enlarged view illustrating a portion E4 of FIG. 29A.

Referring to FIGS. 29A, 29B, 29C, and 29D, the semiconductor device may include active pillars ACPg, gate insulating patterns GOg, bit lines BLg, word lines WLg, and protection patterns PIg.

The bit lines BLg may include a first bit line BLg1 and a second bit line BLg2. The word line WLg may include a first word line WLg1 and a second word line WLg2. The active pillars ACPg may include a first active pillar ACPg1, a second active pillar ACPg2, a third active pillar ACPg3, and a fourth active pillar ACPg4.

The semiconductor device may further include insulating pillars IIPg between the active pillars ACPg. The insulating pillars IIPg may be spaced apart from each other in the first direction D1, with the protection pattern PIg interposed therebetween. The insulating pillars IIPg may be spaced apart from each other in the second direction D2, with the active pillars ACPg interposed therebetween.

The insulating pillars IIPg may include a first insulating pillar IIPg1 and a second insulating pillar IIPg2, which are spaced apart from each other in the first direction D1. The first insulating pillar IIPg1 may be disposed between a first active pillar ACPg1 and a third active pillar ACPg3. The first insulating pillar IIPg1 may be in contact with the first active pillar ACPg1 and the third active pillar ACPg3. The second insulating pillar IIPg2 may be disposed between a second active pillar ACPg2 and a fourth active pillar ACPg4. The second insulating pillar IIPg2 may be in contact with the second active pillar ACPg2 and the fourth active pillar ACPg4.

The gate insulating pattern GOg may include a first gate insulating pattern GOg1 and a second gate insulating pattern GOg2, which are spaced apart from each other in the first direction D1. The first gate insulating pattern GOg1 may enclose the first active pillar ACPg1, the third active pillar ACPg3, and the first insulating pillar IIPg1. The second gate insulating pattern GOg2 may enclose side surfaces of the second active pillar ACPg2, the fourth active pillar ACPg4, and the second insulating pillar IIPg2.

The word lines WLg may include a first word line WL1g and a second word line WL2g, which are spaced apart from each other in the first direction D1. The first and second word lines WL1g and WL2g may conformally cover a side surface of the gate insulating pattern GOg. The gate insulating patterns GOg may be disposed between the first and second word lines WL1g and WL2g. The first and second word lines WL1g and WL2g may be alternatingly disposed, with the gate insulating pattern GOg or a word line insulating layer WILg interposed therebetween.

The protection pattern PIg may be disposed between the first and second word lines WL1g and WL2g. The protection pattern PIg may include an exposed surface. The air gap AGg may be defined by the exposed surface of the protection pattern PIg.

A width of the active pillar ACPg in the first direction D1 may be larger than a width of the insulating pillar IIPg in the first direction D1. A width W1, in the first direction D1, of the air gap AGg between the active pillars ACPg may be smaller than a width W2, in the first direction D1, of the air gap AGg between the insulating pillars IIPg.

According to some embodiments of the inventive concept, a semiconductor device may include a protection pattern defining an air gap, and thus, it may be possible to reduce an interference issue between word lines and improve electrical characteristics of the semiconductor device.

As used herein, the terms "comprises", "comprising", "includes", "including", "has", "having" and any other variations thereof specify the presence of the stated features, steps, operations, elements, components, and/or groups but do not preclude the presence or addition of one or more other features, steps, operations, elements, components, and/or groups thereof. It will be understood that, although the terms first, second, etc. may be used herein to describe various elements, these elements should not be limited by these terms. Rather, these terms are only used to distinguish one element from another. For example, a first element could be termed a second element, and, similarly, a second element could be termed a first element, without departing from the scope of the present disclosure.

While example embodiments of the inventive concept have been particularly shown and described, it will be understood by one of ordinary skill in the art that variations in form and detail may be made therein without departing from the spirit and scope of the attached claims.

## Claims

1. A semiconductor device, comprising:
a first bit line that extends in a first direction;
a first active pillar and a second active pillar on the first bit line;
a first gate insulating pattern on the first active pillar;
a second gate insulating pattern on the second active pillar;
a first word line and a second word line that extend in a second direction that intersects the first direction; and
a protection pattern between the first and second word lines,
wherein an air gap is between the first and second word lines and is adjacent the protection pattern.

2. The semiconductor device of claim 1, wherein each of the first and second active pillars has a tetragonal or rectangular shape, and
wherein a width of the first active pillar in the first direction is less than a width of the first active pillar in the second direction.

3. The semiconductor device of claim 1, further comprising:
an insulating structure on the first word line, the second word line, and the protection pattern,
wherein the insulating structure is between the first and second gate insulating patterns.

4. The semiconductor device of claim 3, wherein the insulating structure comprises:
a first vertical portion in contact with a top surface of the first word line;
a second vertical portion in contact with a top surface of the second word line; and
a horizontal portion connecting the first and second vertical portions to each other,
wherein a distance of a top surface of the horizontal portion from a substrate is greater than respective distances of respective top surfaces of each of the first and second word lines from the substrate.

5. The semiconductor device of claim 4, wherein the first vertical portion of the insulating structure is between the first active pillar and the protection pattern, and
wherein the second vertical portion of the insulating structure is between the second active pillar and the protection pattern.

6. The semiconductor device of claim 1, wherein the first gate insulating pattern comprises:
a first sidewall that extends in the first direction;
a second sidewall that extends in the second direction;
a third sidewall spaced apart from the first sidewall in the second direction; and
a fourth sidewall spaced apart from the second sidewall in the first direction,
wherein the first, second, third, and fourth sidewalls of the first gate insulating pattern are in contact with the first word line.

7. The semiconductor device of claim 1, wherein each of the first and second active pillars has an elliptical shape.

8. The semiconductor device of claim 7, wherein the first word line comprises an outer side surface in contact with the protection pattern, and
wherein the outer side surface of the first word line has a curved shape.

9. The semiconductor device of claim 8, wherein the protection pattern comprises an exposed surface defining the air gap, and
wherein the exposed surface of the protection pattern has a curved shape.

10. The semiconductor device of claim 1, further comprising:
a second bit line spaced apart from the first bit line in the second direction;
a third active pillar on the second bit line; and
an insulating pillar between the first and third active pillars,
wherein the first gate insulating pattern is on the first active pillar, the third active pillar, and the insulating pillar in plan view.

11. The semiconductor device of claim 1, wherein a length of the air gap in the second direction is greater than respective lengths of each of the first and second gate insulating patterns in the second direction.

12. A semiconductor device, comprising:
a first bit line that extends in a first direction;
a first active pillar and a second active pillar on the first bit line;
a first gate insulating pattern on the first active pillar;
a second gate insulating pattern on the second active pillar;
a first word line and a second word line that extend in a second direction that intersects the first direction; and
a protection pattern between the first and second word lines,
wherein the protection pattern comprises a first portion in contact with the first word line and a second portion in contact with the second word line, and
wherein an air gap is between the first and second portions of the protection pattern.

13. The semiconductor device of claim 12, wherein the protection pattern further comprises a third portion connecting the first and second portions to each other,
wherein the first and second portions of the protection pattern are adjacent to side surfaces of the air gap, and
wherein the third portion of the protection pattern is on a top surface of the air gap.

14. The semiconductor device of claim 12, further comprising:
a blocking pattern between the first and second portions of the protection pattern,
wherein the blocking pattern has a top surface adjacent a bottom surface of the air gap.

15. The semiconductor device of claim 14, wherein a distance from the top surface of the air gap to a substrate is greater than a distance of the first word line to the substrate.
